# EUROPEAN PATENT APPLICATION

(11) **EP 4 751 907 A1**
(43) Date of publication of application: **03.06.2026**
(21) Application number: 25772821.2
(22) Date of filing: 21.02.2025
(51) Int. Cl.: B32B 17/04, B32B 17/12, B32B 27/02, B32B 27/32, B32B 27/04, B32B 27/12, B32B 33/00, B32B 37/10, B32B 38/14, B32B 37/24, B32B 38/00, H05K 5/02

(54) **COMPOSITE MATERIAL STRUCTURE, SHELL AND ELECTRONIC DEVICE**

(30) Priority: 19.03.2024 CN 202410316359
(71) Applicant: Huawei Technologies Co., Ltd., Shenzhen, Guangdong 518129 (CN)
(72) Inventor: HE, Yisong, Shenzhen, Guangdong 518129 (CN); XU, Yanxiang, Shenzhen, Guangdong 518129 (CN); LI, Qingmeng, Shenzhen, Guangdong 518129 (CN); XU, Feng, Shenzhen, Guangdong 518129 (CN); YUAN, Hang, Shenzhen, Guangdong 518129 (CN); ZHOU, Qing, Shenzhen, Guangdong 518129 (CN); CHEN, Yixiao, Shenzhen, Guangdong 518129 (CN); NIU, Jianwei, Shenzhen, Guangdong 518129 (CN); TAN, Jingbiao, Shenzhen, Guangdong 518129 (CN)
(74) Representative: Thun, Clemens
(86) International application number: PCT/CN2025/078499
(87) International publication number: WO 2025/195112

(57) **Abstract**

This application provides a composite material structure, a housing, and an electronic device. The composite material structure may be used in a housing or an electronic device. The composite material structure includes at least one layer of first fiber prepreg. The first fiber prepreg includes a fiber sheet and resin wrapping the fiber sheet. The fiber sheet includes a fiber fabric and a plurality of film plating layers located on a surface of the fiber fabric. A difference between refractive indexes of two adjacent layers of the plurality of film plating layers is greater than or equal to 0.4. In the composite material structure provided in this application, a difference in brightness is formed due to the difference between the refractive indexes of adjacent plating layers, to improve appearance aesthetics of the fiber composite material when the fiber composite material is used in the housing and the electronic device.

## Description

This application claims priority to Chinese Patent Application No. 202410316359.3, filed with the China National Intellectual Property Administration on March 19, 2024, and entitled "COMPOSITE MATERIAL STRUCTURE, HOUSING, AND ELECTRONIC DEVICE", which is incorporated herein by reference in its entirety.

### TECHNICAL FIELD

This application relates to the field of electronic devices, and more specifically, to a composite material structure, a housing, and an electronic device.

### BACKGROUND

A fiber composite material has characteristics such as high strength and low density. When used as a housing material of an electronic device, the fiber composite material has advantages of being lightweight and not prone to breakage upon falling. Therefore, the fiber composite material is a key housing material for a future electronic device. Due to a molding process of the fiber composite material and characteristics of a composite material, fiber texture is likely to be visible on a housing base, resulting in ordinary perception of quality and poor aesthetics. Especially, when the fiber composite material is used as a rear cover material of high-end products such as a flagship mobile phone and a tablet computer, overall aesthetics and a sense of value of the product are greatly affected.

Currently, an appearance processing process for the housing base is mainly spray coating combined with rubbing, flow coating combined with transfer printing, or flow coating combined with rubbing. However, these conventional processes contribute to merely planar effect, but fail to achieve differentiation. These conventional processes cannot bring richer appearance effect to consumers and improve appearance aesthetics of the product.

### SUMMARY

This application provides a composite material structure, a housing, and an electronic device. A bright line or a dazzling light sense can be implemented by using the composite material structure. When the composite material structure is used in the housing and the electronic device, appearance effect of the housing and the electronic device can be enriched, and appearance aesthetics of the housing and the electronic device can be improved.

According to a first aspect, a composite material structure is provided. The composite material structure includes at least one layer of a first fiber prepreg. The first fiber prepreg includes a fiber sheet and resin wrapping the fiber sheet. The fiber sheet includes a fiber fabric and a plurality of film plating layers located on a surface of the fiber fabric. A difference between refractive indexes of two adjacent layers of the plurality of film plating layers is greater than or equal to 0.4.

The first fiber prepreg may be understood as a fiber composite material preimpregnated with resin, and the first fiber prepreg may be a fiber prepreg sheet having brightening effect.

For example, the fiber fabric may be a woven fabric, or may be a mesh fabric, a felt fabric, or the like. A material of the fiber fabric may include any one of the following: glass fiber, basalt fiber, carbon fiber, aramid fiber, ceramic fiber, polyethylene terephthalate fiber (PET fiber), ultra-high molecular weight polyethylene fiber (UHMWPE fiber), poly(p-phenylene benzobisoxazole) fiber (PBO fiber), polyimide fiber (PI fiber), polypropylene fiber, bast and leaf fiber, and bamboo fiber. The fiber fabric may be colored or colorless. The material of the fiber fabric is preferably glass fiber, followed by UHMWPE fiber.

For example, the fiber sheet includes the fiber fabric and the plurality of film plating layers located on the surface of the fiber fabric. The plurality of film plating layers located on the surface of the fiber fabric may also be referred to as an effect layer (an effect layer having brightening effect), and the effect layer may be obtained through film plating. In other words, some colored film plating layers or brightening reflective effect layers may be plated on the fiber fabric, so that the finally obtained composite material structure can present a bright line or a colored dazzling light sense.

In this embodiment of this application, the difference between the refractive indexes of two adjacent layers of the plurality of film plating layers in the composite material structure is limited to 0.4 or more, that is, a material with a low refractive index and a material with a high refractive index are sequentially and repeatedly stacked, so that bright line effect or bright sheet effect can be formed based on a difference in brightness formed due to a difference between refractive indexes. When the composite material structure is used in a housing and an electronic device, appearance effect of the housing and the electronic device can be enriched, and appearance aesthetics of the housing and the electronic device can be improved.

It should be noted that bright lines or bright sheets formed in embodiments of this application may be ordered or unordered. This is not limited in this application. Regular bright lines or bright sheets may be manufactured and formed according to an actual requirement, or unordered bright lines or bright sheets may be manufactured and formed.

With reference to the first aspect, in some implementations of the first aspect, the plurality of film plating layers include a plurality of first plating layers and a plurality of second plating layers that are alternately stacked, and a total thickness of the first plating layers and the second plating layers ranges from 600 nm to 2000 nm. That is, a total thickness of the plurality of film plating layers ranges from 600 nm to 2000 nm. For example, the first plating layer may be in contact with the fiber fabric. That is, the fiber fabric is first plated with the first plating layer, then plated with the second plating layer, then plated with the first plating layer, and then plated with the second plating layer for sequential stacking.

It should be understood that the thickness of the plurality of film plating layers is limited to a proper range, so that bright line effect or bright sheet effect presented by the effect layer is better. In addition, reliability of the film plating layer is higher, and manufacturing costs are reduced accordingly.

For example, the first plating layer may be any one of silicon dioxide (SiO₂), zirconium dioxide (ZrO₂), or monocrystalline silicon, and the second plating layer may be any one of niobium pentoxide (Nb₂O₅), titanium dioxide (TiO₂), or silicon nitride (Si₃N₄).

For example, the resin wrapping the fiber sheet may include at least one of the following: acetate fiber ester, nylon, polyurethane, polycarbonate, poly(methyl methacrylate), polyethylene terephthalate, epoxy resin, acrylic resin, phenolic resin, and silicon resin.

For example, the plurality of film plating layers may include SiO₂/Nb₂O₅ repeated in at least two sets of stacked layers, or SiO₂/TiO₂ repeated in at least two sets of stacked layers. That is, the plurality of film plating layers may include at least four stacked layers, which may be Si0₂/Nb₂O₅/SiO₂/Nb₂O₅ stacked layers or SiO₂/TiO₂/SiO₂/TiO₂ stacked layers, and a difference between refractive indexes of two adjacent layers is greater than or equal to 0.4.

For example, to achieve better bright line visual effect or bright sheet visual effect, the plurality of film plating layers may include five stacked layers, which may be SiO₂/Nb₂0₅/SiO₂/Nb₂0₅/SiO₂ stacked layers or SiO₂/TiO₂/SiO₂/TiO₂/SiO₂ stacked layers, and a difference between refractive indexes of two adjacent layers is greater than or equal to 0.4.

For example, in this embodiment of this application, deposits may be deposited on the surface (one surface or two surfaces) of the fiber fabric in a vacuum physical deposition manner, for example, deposited on a surface of glass fiber in the vacuum physical deposition manner. The deposits may be SiO₂/Nb₂O₅ or SiO₂/TiO₂ repeated in at least two sets of stacked layers.

With reference to the first aspect, in some implementations of the first aspect, a thickness of one layer of first fiber prepreg ranges from 0.07 mm to 0.15 mm. In some embodiments, the thickness of one layer of first fiber prepreg may range from 0.08 mm to 0.11 mm. The thickness of the first fiber prepreg is limited, so that the finally obtained composite material structure is within a specific range. Therefore, when the composite material structure is used in the housing, a thickness of the housing is within a specific range, to avoid the housing being excessively thick.

With reference to the first aspect, in some implementations of the first aspect, the resin wrapping the fiber sheet is modified resin containing fluorine, and a refractive index of the modified resin containing fluorine ranges from 1.3 to 1.4.

It should be understood that the impregnated resin in the first fiber prepreg may be resin containing fluorine, and the refractive index of the impregnated resin ranges from 1.3 to 1.4, and is less than a refractive index of conventional resin (the refractive index of the conventional resin ranges approximately from 1.5 to 1.6). When observing the composite material structure, a human eye first sees air, then the resin, and finally the effect layer (the plurality of film plating layers). If the refractive index of the resin is high, effect of the seen effect layer is greatly reduced. If the refractive index of the resin is low, the bright lines or bright sheets of the effect layer are more clear in visual effect, and present effect is better.

In addition, if the resin containing fluorine is not used, to maintain good visual effect, the thickness of the film plating layers needs to be large (for example, 2000 nm). A thicker film plating layer may cause a reliability risk and increase costs. If the resin containing fluorine is used, the thickness of the film plating layers can be reduced to 1200 nm or even 1000 nm. In this way, a problem of thick film plating of the effect layer can be further resolved, to reduce reliability and mass production risks, and reduce costs.

With reference to the first aspect, in some implementations of the first aspect, the composite material structure further includes at least one layer of second fiber prepreg stacked with the first fiber prepreg, and the second fiber prepreg includes a fiber woven fabric and resin wrapping the fiber woven fabric.

The second fiber prepreg may be understood as a fiber composite material preimpregnated with resin. The fiber composite material herein may be a fiber woven fabric. Therefore, the second fiber prepreg may also be referred to as a fiber prepreg fabric.

It should be noted that, the second fiber prepreg is a fiber woven fabric impregnated with the to-be-cured resin, and the first fiber prepreg is a fiber sheet impregnated with the to-be-cured resin. A main difference between the first fiber prepreg and the second fiber prepreg lies in impregnated-layer materials in the to-be-cured resin. An impregnated material of the second fiber prepreg is the fiber woven fabric, and an impregnated material of the first fiber prepreg is the fiber sheet provided in this application. The fiber sheet includes the plurality of film plating layers, and the plurality of film plating layers can achieve brightening effect.

For example, a quantity of stacked layers included by the composite material structure ranges from two to eight, and preferably, the quantity of stacked layers may range from two to five. The first fiber prepreg may be at any layer, preferably at any one of first to third layers, and remaining stacked layers may be second fiber prepregs.

For example, the second fiber prepreg may be colored, colorless and translucent, or colorless and transparent, and is preferably colorless and transparent.

It should be understood that, to avoid blocking the first fiber prepreg, a second fiber prepreg above the first fiber prepreg may be colorless and transparent. A second fiber prepreg under the first fiber prepreg may be colored or colorless and transparent, which is not limited herein.

For example, the resin wrapping the fiber woven fabric may include at least one of the following: acetate fiber ester, nylon, polyurethane, polycarbonate, poly(methyl methacrylate), polyethylene terephthalate, epoxy resin, acrylic resin, phenolic resin, and silicon resin.

For example, a material of the fiber woven fabric may include any one of the following: glass fiber, basalt fiber, carbon fiber, aramid fiber, ceramic fiber, PET fiber, UHMWPE fiber, PBO fiber, PI fiber, polypropylene fiber, bast and leaf fiber, and bamboo fiber. The material of the fiber woven fabric is preferably glass fiber, followed by UHMWPE fiber.

For example, a thickness of one layer of second fiber prepreg ranges from 0.07 mm to 0.15 mm. In some embodiments, the thickness of one layer of second fiber prepreg may range from 0.08 mm to 0.11 mm. The thickness of the second fiber prepreg is limited, so that the finally obtained composite material structure is within a specific range. Therefore, when the composite material structure is used in the housing, the thickness of the housing is within a specific range, to avoid the housing being excessively thick.

With reference to the first aspect, in some implementations of the first aspect, to present good visual effect, fiber (namely, fiber filaments) forming the fiber fabric should not be excessively thick, and a maximum cross-sectional width of the fiber (namely, fiber filaments) forming the fiber fabric ranges from 1 µm to 30 µm. Optionally, to present higher visual effect, the maximum cross-sectional width of the fiber forming the fiber fabric may range from 3 µm to 10 µm.

For example, a cross section of the fiber (namely, fiber filaments) that forms the fiber fabric may be solid or hollow. When the cross section is of a hollow structure, an annular bright line may be formed.

For example, a shape of the cross section of the fiber (namely, fiber filaments) that forms the fiber fabric may be one of a circle, a square, or a polygon.

With reference to the first aspect, in some implementations of the first aspect, the composite material structure further includes a first coating layer, and the first coating layer is located on a side that is of the plurality of film plating layers and that is away from the fiber fabric. For example, the first coating layer includes a first texture layer, a first bonding layer, a second texture layer, and a second bonding layer that are sequentially stacked. The first texture layer is an outer texture layer, the outer texture layer is a surface layer that may be touched by a human hand, and the outer texture layer can enhance a tactile feeling. The second texture layer is an inner texture layer, and cannot be directly touched by a human hand. The first bonding layer and the second bonding layer are transition bonding layers. The first bonding layer is connected between the first texture layer and the second texture layer, and the second bonding layer may be connected to the first fiber prepreg. Therefore, the formed composite material structure may sequentially include the fiber fabric, the plurality of film plating layers, the second bonding layer, the second texture layer, the first bonding layer, and the first texture layer from a bottom layer to a top layer. The fiber fabric is an innermost layer and cannot be directly touched by a human hand, and the first texture layer is an outermost layer and may be directly touched by a human hand.

For example, film plating may be performed on the second texture layer, deposits for film plating are SiO₂/Nb₂O₅ or SiO₂/TiO₂ repeated in at least two sets of stacked layers, and a total thickness of film plating layers on the second texture layer ranges from 50 nm to 400 nm.

It should be understood that the second texture layer is matched with the first fiber prepreg provided in this application, or the second texture layer is matched with the plurality of film plating layers provided in this application, so that spatially layered effect and spatial effect of stacking can be visually presented. In this way, the obtained composite material structure or housing is more aesthetic.

For example, when the first fiber prepreg and/or the second fiber prepreg are/is colorless and transparent, the composite material structure may further include a second coating layer. The second coating layer is located on a side that is of the fiber fabric and that is away from the plurality of film plating layers, and the second coating layer is a colored coating layer. It should be understood that the second coating layer mainly serves to shield an electronic component, and can achieve bottoming effect. For example, a base color (of the second coating layer) may be uniform red, white, black, or the like.

According to a second aspect, a composite material structure is provided. The composite material structure includes at least one layer of first fiber prepreg. The first fiber prepreg includes a fiber sheet and resin wrapping the fiber sheet. The fiber sheet includes a fiber fabric and a plurality of film plating layers located on a surface of the fiber fabric, and the plurality of film plating layers include a metal plating layer and third plating layers disposed on two sides of the metal plating layer.

The first fiber prepreg may be understood as a fiber composite material preimpregnated with resin, and the first fiber prepreg may be a fiber prepreg sheet having brightening effect.

For example, the fiber fabric may be a woven fabric, or may be a mesh fabric, a felt fabric, or the like. A material of the fiber fabric may include any one of the following: glass fiber, basalt fiber, carbon fiber, aramid fiber, ceramic fiber, PET fiber, UHMWPE fiber, PBO fiber, PI fiber, polypropylene fiber, bast and leaf fiber, and bamboo fiber. The fiber fabric may be colored or colorless. The material of the fiber fabric is preferably glass fiber, followed by UHMWPE fiber.

For example, the fiber sheet includes the fiber fabric and the plurality of film plating layers located on the surface of the fiber fabric. The plurality of film plating layers located on the surface of the fiber fabric may also be referred to as an effect layer (an effect layer having brightening effect), and the effect layer may be obtained through film plating. In other words, some colored film plating layers or brightening reflective effect layers may be plated on the fiber fabric, so that the finally obtained composite material structure can present a bright line or a colored dazzling light sense.

In this embodiment of this application, the plurality of film plating layers in the composite material structure may include a metal plating layer. In other words, the metal plating layer may be plated on the surface of the fiber fabric. Because the metal plating layer has high reflectivity, bright line effect or shining effect can be formed through reflection of a metal component. When the composite material structure is used in a housing and an electronic device, appearance effect of the housing and the electronic device can be enriched, and appearance aesthetics of the housing and the electronic device can be improved.

It should be noted that bright lines or bright sheets formed in embodiments of this application may be ordered or unordered. This is not limited in this application. Regular bright lines or bright sheets may be manufactured and formed according to an actual requirement, or unordered bright lines or bright sheets may be manufactured and formed.

With reference to the second aspect, in some implementations of the second aspect, the metal plating layer is any one of gold, silver, aluminum, indium, nickel, titanium, or chromium, and the third plating layer is any one of silicon dioxide, zirconium dioxide, or monocrystalline silicon.

It should be understood that the metal plating layer may be made of a metal material with high reflectivity, such as gold, silver, aluminum, indium, nickel, titanium, or chromium. In addition, the third plating layers are located on the two sides of the metal plating layer. The third plating layer is a stable material, such as silicon dioxide, zirconium dioxide, or monocrystalline silicon. The third plating layer can protect the metal plating layer, and can prevent corrosion, oxidation, or the like on the metal plating layer.

For example, the plurality of film plating layers may include SiO₂/In/SiO₂ stacked layers. That is, the plurality of film plating layers may include three stacked layers, which may sequentially be a silicon dioxide layer, an indium layer, and a silicon dioxide layer. The silicon dioxide layer is in contact with the fiber fabric.

For example, in this embodiment of this application, deposits may be deposited on the surface (one surface or two surfaces) of the fiber fabric in a vacuum physical deposition manner, for example, deposited on a surface of glass fiber in the vacuum physical deposition manner. The deposits may be SiO₂/In/SiO₂ stacked layers.

With reference to the second aspect, in some implementations of the second aspect, a total thickness of the plurality of film plating layers ranges from 50 nm to 400 nm, and a thickness of the metal plating layer ranges from 2 nm to 20 nm.

It should be understood that the thicknesses of the plurality of film plating layers and the metal plating layer are limited to proper ranges, so that bright line effect or bright sheet effect presented by the effect layer is better. In addition, reliability of the film plating layer is higher, and manufacturing costs are reduced accordingly.

For example, the resin wrapping the fiber sheet may include at least one of the following: acetate fiber ester, nylon, polyurethane, polycarbonate, poly(methyl methacrylate), polyethylene terephthalate, epoxy resin, acrylic resin, phenolic resin, and silicon resin.

With reference to the second aspect, in some implementations of the second aspect, a thickness of one layer of first fiber prepreg ranges from 0.07 mm to 0.15 mm. In some embodiments, the thickness of one layer of first fiber prepreg may range from 0.08 mm to 0.11 mm. The thickness of the first fiber prepreg is limited, so that the finally obtained composite material structure is within a specific range. Therefore, when the composite material structure is used in the housing, a thickness of the housing is within a specific range, to avoid the housing being excessively thick.

With reference to the second aspect, in some implementations of the second aspect, the resin wrapping the fiber sheet is modified resin containing fluorine, and a refractive index of the modified resin containing fluorine ranges from 1.3 to 1.4.

It should be understood that the impregnated resin in the first fiber prepreg may be resin containing fluorine, and the refractive index of the impregnated resin ranges from 1.3 to 1.4, and is less than a refractive index of conventional resin (the refractive index of the conventional resin ranges approximately from 1.5 to 1.6). When observing the composite material structure, a human eye first sees air, then the resin, and finally the effect layer. If the refractive index of the resin is high, effect of the seen effect layer is greatly reduced. If the refractive index of the resin is low, the bright lines or bright sheets of the effect layer are more clear in visual effect, and present effect is better.

In addition, if the resin containing fluorine is not used, to maintain good visual effect, the thickness of the film plating layers needs to be large (for example, 2000 nm). A thicker film plating layer may cause a reliability risk and increase costs. If the resin containing fluorine is used, the thickness of the film plating layers can be reduced to 1200 nm or even 1000 nm. In this way, a problem of thick film plating of the effect layer can be further resolved, to reduce reliability and mass production risks.

With reference to the second aspect, in some implementations of the second aspect, the composite material structure further includes at least one layer of second fiber prepreg stacked with the first fiber prepreg, and the second fiber prepreg includes a fiber woven fabric and resin wrapping the fiber woven fabric.

The second fiber prepreg may be understood as a fiber composite material preimpregnated with resin. The fiber composite material herein may be a fiber woven fabric. Therefore, the second fiber prepreg may also be referred to as a fiber prepreg fabric.

It should be noted that, the second fiber prepreg is a fiber woven fabric impregnated with the to-be-cured resin, and the first fiber prepreg is a fiber sheet impregnated with the to-be-cured resin. A main difference between the first fiber prepreg and the second fiber prepreg lies in impregnated-layer materials in the to-be-cured resin. An impregnated material of the second fiber prepreg is the fiber woven fabric, and an impregnated material of the first fiber prepreg is the fiber sheet provided in this application. The fiber sheet includes the plurality of film plating layers, and the plurality of film plating layers can achieve brightening effect.

For example, a quantity of stacked layers included by the composite material structure ranges from two to eight, and preferably, the quantity of stacked layers may range from two to five. The first fiber prepreg may be at any layer, preferably at any one of first to third layers, and remaining stacked layers may be second fiber prepregs.

For example, the second fiber prepreg may be colored, colorless and translucent, or colorless and transparent, and is preferably colorless and transparent.

It should be understood that, to avoid blocking the first fiber prepreg, a second fiber prepreg above the first fiber prepreg needs to be colorless and transparent. A second fiber prepreg under the first fiber prepreg may be colored or colorless and transparent, which is not limited herein.

For example, the resin wrapping the fiber woven fabric may include at least one of the following: acetate fiber ester, nylon, polyurethane, polycarbonate, poly(methyl methacrylate), polyethylene terephthalate, epoxy resin, acrylic resin, phenolic resin, and silicon resin.

For example, a material of the fiber woven fabric may include any one of the following: glass fiber, basalt fiber, carbon fiber, aramid fiber, ceramic fiber, PET fiber, UHMWPE fiber, PBO fiber, PI fiber, polypropylene fiber, bast and leaf fiber, and bamboo fiber. The material of the fiber woven fabric is preferably glass fiber, followed by UHMWPE fiber.

For example, a thickness of one layer of second fiber prepreg ranges from 0.07 mm to 0.15 mm. In some embodiments, the thickness of one layer of second fiber prepreg may range from 0.08 mm to 0.11 mm. The thickness of the second fiber prepreg is limited, so that the finally obtained composite material structure is within a specific range. Therefore, when the composite material structure is used in the housing, the thickness of the housing is within a specific range, to avoid the housing being excessively thick.

With reference to the second aspect, in some implementations of the second aspect, to present good visual effect, fiber (namely, fiber filaments) forming the fiber fabric should not be excessively thick, and a maximum cross-sectional width of the fiber (namely, fiber filaments) forming the fiber fabric ranges from 1 µm to 30 µm. Optionally, to present higher visual effect, the maximum cross-sectional width of the fiber forming the fiber fabric may range from 3 µm to 10 µm.

For example, a cross section of the fiber (namely, fiber filaments) that forms the fiber fabric may be solid or hollow. When the cross section is of a hollow structure, an annular bright line may be formed.

For example, a shape of the cross section of the fiber (namely, fiber filaments) that forms the fiber fabric may be one of a circle, a square, or a polygon.

With reference to the second aspect, in some implementations of the second aspect, the composite material structure further includes a first coating layer, and the first coating layer is located on a side that is of the plurality of film plating layers and that is away from the fiber fabric. For example, the first coating layer includes a first texture layer, a first bonding layer, a second texture layer, and a second bonding layer that are sequentially stacked. The first texture layer is an outer texture layer, the outer texture layer is a surface layer that may be touched by a human hand, and the outer texture layer can enhance a tactile feeling. The second texture layer is an inner texture layer, and cannot be directly touched by a human hand. The first bonding layer and the second bonding layer are transition bonding layers. The first bonding layer is connected between the first texture layer and the second texture layer, and the second bonding layer may be connected to the first fiber prepreg. Therefore, the formed composite material structure may sequentially include the fiber fabric, the plurality of film plating layers, the second bonding layer, the second texture layer, the first bonding layer, and the first texture layer from a bottom layer to a top layer. The fiber fabric is an innermost layer and cannot be directly touched by a human hand, and the first texture layer is an outermost layer and may be directly touched by a human hand.

For example, film plating may be performed on the second texture layer, deposits for film plating are SiO₂/Nb₂O₅ or SiO₂/TiO₂ repeated in at least two sets of stacked layers, and a total thickness of film plating layers on the second texture layer ranges from 50 nm to 400 nm.

It should be understood that the second texture layer is matched with the first fiber prepreg provided in this application, or the second texture layer is matched with the plurality of film plating layers provided in this application, so that spatially layered effect and spatial effect of stacking can be visually presented. In this way, the obtained composite material structure or housing is more aesthetic.

For example, when the first fiber prepreg and/or the second fiber prepreg are/is colorless and transparent, the composite material structure may further include a second coating layer. The second coating layer is located on a side that is of the fiber fabric and that is away from the plurality of film plating layers, and the second coating layer is a colored coating layer. It should be understood that the second coating layer mainly serves to shield an electronic component, and can achieve bottoming effect. For example, a base color (of the second coating layer) may be uniform red, white, black, or the like.

According to a third aspect, a composite material structure is provided. The composite material structure includes at least one layer of first fiber prepreg. The first fiber prepreg includes a fiber sheet and resin wrapping the fiber sheet. The fiber sheet includes a fiber fabric and a hot stamping layer located on a surface of the fiber fabric, and the hot stamping layer is formed on the surface of the fiber fabric through a hot stamping process.

The first fiber prepreg may be understood as a fiber composite material preimpregnated with resin, and the first fiber prepreg may be a fiber prepreg sheet having brightening effect.

It may be understood that, in the hot stamping process, an aluminum layer in electroplated aluminum is transferred onto a surface of a printing substrate according to a hot-press transfer principle, to form special metal effect.

For example, the hot stamping layer may be transferred onto one surface of the fiber fabric through the hot stamping process, or the hot stamping layer may be transferred onto both surfaces of the fiber fabric through the hot stamping process. In other words, a metal foil material may be transferred onto the fiber fabric (such as glass fiber fabric) through the hot stamping process, to form a bright pattern. The metal foil material may be transferred onto one surface or both surfaces. Metal foil may be aluminum foil, gold foil, silver foil, indium foil, or the like, and is preferably aluminum foil and indium foil.

In this embodiment of this application, the composite material structure may include the hot stamping layer. The hot stamping layer may be formed on the surface of the fiber fabric through the hot stamping process. Metal is hot-stamped on the surface of the fiber fabric, so that bright line effect or shining effect is formed through high reflection of a metal component. When the composite material structure is used in a housing and an electronic device, appearance effect of the housing and the electronic device can be enriched, and appearance aesthetics of the housing and the electronic device can be improved.

It should be noted that bright lines or bright sheets formed in embodiments of this application may be ordered or unordered. This is not limited in this application. Regular bright lines or bright sheets may be manufactured and formed according to an actual requirement, or unordered bright lines or bright sheets may be manufactured and formed.

With reference to the third aspect, in some implementations of the third aspect, the hot stamping layer includes any one of the following: gold, silver, aluminum, indium, nickel, titanium, and chromium. A material of the fiber fabric includes any one of the following: glass fiber, basalt fiber, carbon fiber, aramid fiber, ceramic fiber, PET fiber, UHMWPE fiber, PBO fiber, PI fiber, polypropylene fiber, bast and leaf fiber, and bamboo fiber.

For example, the fiber fabric may be a woven fabric, or may be a mesh fabric, a felt fabric, or the like.

With reference to the third aspect, in some implementations of the third aspect, a thickness of the hot stamping layer ranges from 0.01 mm to 0.02 mm. It should be understood that the thickness of the hot stamping layer is limited to a proper range, so that bright line effect or bright sheet effect presented by the effect layer is better. In addition, reliability of the hot stamping layer is higher, and manufacturing costs are reduced accordingly.

With reference to the third aspect, in some implementations of the third aspect, a thickness of one layer of first fiber prepreg ranges from 0.07 mm to 0.15 mm. In some embodiments, the thickness of one layer of first fiber prepreg may range from 0.08 mm to 0.11 mm. The thickness of the first fiber prepreg is limited, so that the finally obtained composite material structure is within a specific range. Therefore, when the composite material structure is used in the housing, a thickness of the housing is within a specific range, to avoid the housing being excessively thick.

With reference to the third aspect, in some implementations of the third aspect, the resin wrapping the fiber sheet is modified resin containing fluorine, and a refractive index of the modified resin containing fluorine ranges from 1.3 to 1.4.

It should be understood that the impregnated resin in the first fiber prepreg may be resin containing fluorine, and the refractive index of the impregnated resin ranges from 1.3 to 1.4, and is less than a refractive index of conventional resin (the refractive index of the conventional resin ranges approximately from 1.5 to 1.6). When observing the composite material structure, a human eye first sees air, then the resin, and finally the effect layer. If the refractive index of the resin is high, effect of the seen effect layer is greatly reduced. If the refractive index of the resin is low, the bright lines or bright sheets of the effect layer are more clear in visual effect, and present effect is better.

In addition, if the resin containing fluorine is not used, to maintain good visual effect, the thickness of the film plating layers needs to be large (for example, 2000 nm). A thicker film plating layer may cause a reliability risk and increase costs. If the resin containing fluorine is used, the thickness of the film plating layers can be reduced to 1200 nm or even 1000 nm. In this way, a problem of thick film plating of the effect layer can be further resolved, to reduce reliability and mass production risks.

With reference to the third aspect, in some implementations of the third aspect, the composite material structure further includes at least one layer of second fiber prepreg stacked with the first fiber prepreg, and the second fiber prepreg includes a fiber woven fabric and resin wrapping the fiber woven fabric.

The second fiber prepreg may be understood as a fiber composite material preimpregnated with resin. The fiber composite material herein may be a fiber woven fabric. Therefore, the second fiber prepreg may also be referred to as a fiber prepreg fabric.

It should be noted that, the second fiber prepreg is a fiber woven fabric impregnated with the to-be-cured resin, and the first fiber prepreg is a fiber sheet impregnated with the to-be-cured resin. A main difference between the first fiber prepreg and the second fiber prepreg lies in impregnated-layer materials in the to-be-cured resin. An impregnated material of the second fiber prepreg is the fiber woven fabric, and an impregnated material of the first fiber prepreg is the fiber sheet provided in this application. The fiber sheet includes the hot stamping layer, and the hot stamping layer can achieve brightening effect.

For example, a quantity of stacked layers included by the composite material structure ranges from two to eight, and preferably, the quantity of stacked layers may range from two to five. The first fiber prepreg may be at any layer, preferably at any one of first to third layers, and remaining stacked layers may be second fiber prepregs.

For example, the second fiber prepreg may be colored, colorless and translucent, or colorless and transparent, and is preferably colorless and transparent.

It should be understood that, to avoid blocking the first fiber prepreg, a second fiber prepreg above the first fiber prepreg needs to be colorless and transparent. A second fiber prepreg under the first fiber prepreg may be colored or colorless and transparent, which is not limited herein.

For example, the resin wrapping the fiber woven fabric may include at least one of the following: acetate fiber ester, nylon, polyurethane, polycarbonate, poly(methyl methacrylate), polyethylene terephthalate, epoxy resin, acrylic resin, phenolic resin, and silicon resin.

For example, a material of the fiber woven fabric may include any one of the following: glass fiber, basalt fiber, carbon fiber, aramid fiber, ceramic fiber, PET fiber, UHMWPE fiber, PBO fiber, PI fiber, polypropylene fiber, bast and leaf fiber, and bamboo fiber. The material of the fiber woven fabric is preferably glass fiber, followed by UHMWPE fiber.

For example, a thickness of one layer of second fiber prepreg ranges from 0.07 mm to 0.15 mm. In some embodiments, the thickness of one layer of second fiber prepreg may range from 0.08 mm to 0.11 mm. The thickness of the second fiber prepreg is limited, so that the finally obtained composite material structure is within a specific range. Therefore, when the composite material structure is used in the housing, the thickness of the housing is within a specific range, to avoid the housing being excessively thick.

With reference to the third aspect, in some implementations of the third aspect, to present good visual effect, fiber (namely, fiber filaments) forming the fiber fabric should not be excessively thick, and a maximum cross-sectional width of the fiber (namely, fiber filaments) forming the fiber fabric ranges from 1 µm to 30 µm. Optionally, to present higher visual effect, the maximum cross-sectional width of the fiber forming the fiber fabric may range from 3 µm to 10 µm.

For example, a cross section of the fiber (namely, fiber filaments) that forms the fiber fabric may be solid or hollow. When the cross section is of a hollow structure, an annular bright line may be formed.

For example, a shape of the cross section of the fiber (namely, fiber filaments) that forms the fiber fabric may be one of a circle, a square, or a polygon.

With reference to the third aspect, in some implementations of the third aspect, the composite material structure further includes a first coating layer, and the first coating layer is located on a side that is of the hot stamping layer and that is away from the fiber fabric. For example, the first coating layer includes a first texture layer, a first bonding layer, a second texture layer, and a second bonding layer that are sequentially stacked. The first texture layer is an outer texture layer, the outer texture layer is a surface layer that may be touched by a human hand, and the outer texture layer can enhance a tactile feeling. The second texture layer is an inner texture layer, and cannot be directly touched by a human hand. The first bonding layer and the second bonding layer are transition bonding layers. The first bonding layer is connected between the first texture layer and the second texture layer, and the second bonding layer may be connected to the first fiber prepreg. Therefore, the formed composite material structure may sequentially include the fiber fabric, the hot stamping layer, the second bonding layer, the second texture layer, the first bonding layer, and the first texture layer from a bottom layer to a top layer. The fiber fabric is an innermost layer and cannot be directly touched by a human hand, and the first texture layer is an outermost layer and may be directly touched by a human hand.

For example, film plating may be performed on the second texture layer, deposits for film plating are SiO₂/Nb₂O₅ or SiO₂/TiO₂ repeated in at least two sets of stacked layers, and a total thickness of film plating layers on the second texture layer ranges from 50 nm to 400 nm.

It should be understood that the second texture layer is matched with the first fiber prepreg provided in this application, or the second texture layer is matched with the plurality of film plating layers provided in this application, so that spatially layered effect and spatial effect of stacking can be visually presented. In this way, the obtained composite material structure or housing is more aesthetic.

For example, when the first fiber prepreg and/or the second fiber prepreg are/is colorless and transparent, the composite material structure may further include a second coating layer. The second coating layer is located on a side that is of the fiber fabric and that is away from the first coating layer, and the second coating layer is a colored coating layer. It should be understood that the second coating layer mainly serves to shield an electronic component, and can achieve bottoming effect. For example, a base color (of the second coating layer) may be uniform red, white, black, or the like.

According to a fourth aspect, a manufacturing method for a composite material structure is provided, where the manufacturing method includes: obtaining a fiber fabric; disposing a plurality of film plating layers on a surface of the fiber fabric through a film plating process, where a difference between refractive indexes of two adjacent layers of the plurality of film plating layers is greater than or equal to 0.4; and preimmersing the fiber fabric with the plurality of film plating layers in resin, to form a first fiber prepreg.

It should be understood that the first fiber prepreg formed in the foregoing manner includes a fiber sheet and resin wrapping the fiber sheet.

For example, a material of the fiber fabric may include any one of the following: glass fiber, basalt fiber, carbon fiber, aramid fiber, ceramic fiber, PET fiber, UHMWPE fiber, PBO fiber, PI fiber, polypropylene fiber, bast and leaf fiber, and bamboo fiber. The fiber fabric may be colored or colorless. The material of the fiber fabric is preferably glass fiber, followed by UHMWPE fiber.

For example, the resin may include at least one of the following: acetate fiber ester, nylon, polyurethane, polycarbonate, poly(methyl methacrylate), polyethylene terephthalate, epoxy resin, acrylic resin, phenolic resin, and silicon resin. In some embodiments, to achieve better visual effect, the resin may be modified resin containing fluorine, and a refractive index of the modified resin containing fluorine ranges from 1.3 to 1.4.

In this embodiment of this application, when the composite material structure is manufactured, the plurality of film plating layers may be plated on the surface of the fiber fabric, and the difference between the refractive indexes of two adjacent layers of the plurality of film plating layers is limited to 0.4 or more. That is, a material with a low refractive index and a material with a high refractive index are sequentially and repeatedly stacked, so that bright line effect or bright sheet effect can be formed based on a difference in brightness formed due to a difference between refractive indexes. When the composite material structure is used in a housing and an electronic device, appearance effect of the housing and the electronic device can be enriched, and appearance aesthetics of the housing and the electronic device can be improved.

In some embodiments, the manufacturing method includes: obtaining one or more first fiber prepregs, and stacking the one or more first fiber prepregs, to form the composite material structure.

With reference to the fourth aspect, in some implementations of the fourth aspect, disposing the plurality of film plating layers on the surface of the fiber fabric through the film plating process includes: plating a first film layer on the surface of the fiber fabric; plating a second film layer on a surface that is of the first film layer and that is away from the fiber fabric; plating a third film layer on a surface that is of the second film layer and that is away from the fiber fabric; and plating a fourth film layer on a surface that is of the third film layer and that is away from the fiber fabric. In some embodiments, a fifth film layer may be further plated on a surface that is of the fourth film layer and that is away from the fiber fabric.

The first film layer, the third film layer, and the fifth film layer are the foregoing first plating layers, and the second film layer and the fourth film layer are the foregoing second plating layers. For example, the first plating layer may be any one of silicon dioxide (SiO₂), zirconium dioxide (ZrO₂), or monocrystalline silicon, and the second plating layer may be any one of niobium pentoxide (Nb₂O₅), titanium dioxide (TiO₂), or silicon nitride (Si₃N₄).

With reference to the fourth aspect, in some implementations of the fourth aspect, the manufacturing method further includes: disposing a second fiber prepreg on one side and/or second fiber prepregs on two sides of the first fiber prepreg. The second fiber prepreg is manufactured in an existing manner, and the second fiber prepreg includes a fiber woven fabric and resin wrapping the fiber woven fabric.

It should be understood that, to avoid blocking the first fiber prepreg, a second fiber prepreg above the first fiber prepreg needs to be colorless and transparent. A second fiber prepreg under the first fiber prepreg may be colored or colorless and transparent, which is not limited herein.

For example, a thickness of one layer of second fiber prepreg and a thickness of one layer of first fiber prepreg both range from 0.07 mm to 0.15 mm. In some embodiments, the thickness of one layer of second fiber prepreg and the thickness of one layer of first fiber prepreg both range from 0.08 mm to 0.11 mm. The thickness of the second fiber prepreg and the thickness of the first fiber prepreg are limited, so that the finally obtained composite material structure is within a specific range. Therefore, when the composite material structure is used in the housing, the thickness of the housing is within a specific range, to avoid the housing being excessively thick.

With reference to the fourth aspect, in some implementations of the fourth aspect, the manufacturing method further includes: spraying a first coating layer on a side that is of the plurality of film plating layers and that is away from the fiber fabric.

For example, the first coating layer includes a first texture layer, a first bonding layer, a second texture layer, and a second bonding layer that are sequentially stacked. The first texture layer is an outer texture layer, the outer texture layer is a surface layer that may be touched by a human hand, and the outer texture layer can enhance a tactile feeling. The second texture layer is an inner texture layer, and cannot be directly touched by a human hand. The first bonding layer and the second bonding layer are transition bonding layers. The first bonding layer is connected between the first texture layer and the second texture layer, and the second bonding layer may be connected to the first fiber prepreg. Therefore, the formed composite material structure may sequentially include the fiber fabric, the plurality of film plating layers, the second bonding layer, the second texture layer, the first bonding layer, and the first texture layer from a bottom layer to a top layer. The fiber fabric is an innermost layer and cannot be directly touched by a human hand, and the first texture layer is an outermost layer and may be directly touched by a human hand.

For example, film plating may be performed on the second texture layer, deposits for film plating are SiO₂/Nb₂O₅ or SiO₂/TiO₂ repeated in at least two sets of stacked layers, and a total thickness of film plating layers on the second texture layer ranges from 50 nm to 400 nm.

It should be understood that the second texture layer is matched with the plurality of film plating layers, or the second texture layer is matched with the plurality of film plating layers provided in this application, so that spatially layered effect and spatial effect of stacking can be visually presented. In this way, the obtained composite material structure or housing is more aesthetic.

With reference to the fourth aspect, in some implementations of the fourth aspect, the manufacturing method further includes: spraying a second coating layer on a side that is of the fiber fabric and that is away from the plurality of film plating layers.

It should be understood that, when the first fiber prepreg and/or the second fiber prepreg are/is colorless and transparent, the second coating layer may be further sprayed. The second coating layer is located on the side that is of the fiber fabric and that is away from the plurality of film plating layers, and the second coating layer is a colored coating layer. It should be understood that the second coating layer mainly serves to shield an electronic component, and can achieve bottoming effect. For example, a base color (of the second coating layer) may be uniform red, white, black, or the like.

According to a fifth aspect, a manufacturing method for a composite material structure is provided, where the manufacturing method includes: obtaining a fiber fabric; plating a sixth film layer on a surface of the fiber fabric through a film plating process; plating a metal plating layer on a side that is of the sixth film layer and that is away from the fiber fabric through the film plating process; plating a seventh film layer on a side that is of the metal plating layer and that is away from the sixth film layer through the film plating process; and preimmersing the fiber fabric with a plurality of plating layers (the sixth film layer, the metal plating layer, and the seventh film layer) in resin, to form a first fiber prepreg.

Both the sixth film layer and the seventh film layer are the foregoing third plating layers. For example, the third plating layer is any one of silicon dioxide, zirconium dioxide, or monocrystalline silicon, and the metal plating layer is any one of gold, silver, aluminum, indium, nickel, titanium, or chromium.

It should be understood that the first fiber prepreg formed in the foregoing manner includes a fiber sheet and resin wrapping the fiber sheet.

For example, a material of the fiber fabric may include any one of the following: glass fiber, basalt fiber, carbon fiber, aramid fiber, ceramic fiber, PET fiber, UHMWPE fiber, PBO fiber, PI fiber, polypropylene fiber, bast and leaf fiber, and bamboo fiber. The fiber fabric may be colored or colorless. The material of the fiber fabric is preferably glass fiber, followed by UHMWPE fiber.

For example, the resin may include at least one of the following: acetate fiber ester, nylon, polyurethane, polycarbonate, poly(methyl methacrylate), polyethylene terephthalate, epoxy resin, acrylic resin, phenolic resin, and silicon resin. In some embodiments, to achieve better visual effect, the resin may be modified resin containing fluorine, and a refractive index of the modified resin containing fluorine ranges from 1.3 to 1.4.

In this embodiment of this application, when the composite material structure is manufactured, the plurality of film plating layers (the sixth film layer, the metal plating layer, and the seventh film layer) may be plated on the surface of the fiber fabric, and bright line effect or shining effect can be formed through high reflection of the metal plating layer in the plurality of film plating layers. When the composite material structure is used in a housing and an electronic device, appearance effect of the housing and the electronic device can be enriched, and appearance aesthetics of the housing and the electronic device can be improved.

In some embodiments, the manufacturing method includes: obtaining one or more first fiber prepregs, and stacking the one or more first fiber prepregs, to form the composite material structure.

With reference to the fifth aspect, in some implementations of the fifth aspect, the manufacturing method further includes: disposing a second fiber prepreg on one side and/or second fiber prepregs on two sides of the first fiber prepreg. The second fiber prepreg is manufactured in an existing manner, and the second fiber prepreg includes a fiber woven fabric and resin wrapping the fiber woven fabric.

It should be understood that, to avoid blocking the first fiber prepreg, a second fiber prepreg above the first fiber prepreg needs to be colorless and transparent. A second fiber prepreg under the first fiber prepreg may be colored or colorless and transparent, which is not limited herein.

For example, a thickness of one layer of second fiber prepreg and a thickness of one layer of first fiber prepreg both range from 0.07 mm to 0.15 mm. In some embodiments, the thickness of one layer of second fiber prepreg and the thickness of one layer of first fiber prepreg both range from 0.08 mm to 0.11 mm. The thickness of the second fiber prepreg and the thickness of the first fiber prepreg are limited, so that the finally obtained composite material structure is within a specific range. Therefore, when the composite material structure is used in the housing, the thickness of the housing is within a specific range, to avoid the housing being excessively thick.

With reference to the fifth aspect, in some implementations of the fifth aspect, the manufacturing method further includes: spraying a first coating layer on a side that is of the seventh film layer and that is away from the fiber fabric.

For example, the first coating layer includes a first texture layer, a first bonding layer, a second texture layer, and a second bonding layer that are sequentially stacked. The first texture layer is an outer texture layer, the outer texture layer is a surface layer that may be touched by a human hand, and the outer texture layer can enhance a tactile feeling. The second texture layer is an inner texture layer, and cannot be directly touched by a human hand. The first bonding layer and the second bonding layer are transition bonding layers. The first bonding layer is connected between the first texture layer and the second texture layer, and the second bonding layer may be connected to the first fiber prepreg. Therefore, the formed composite material structure may sequentially include the fiber fabric, the plurality of film plating layers, the second bonding layer, the second texture layer, the first bonding layer, and the first texture layer from a bottom layer to a top layer. The fiber fabric is an innermost layer and cannot be directly touched by a human hand, and the first texture layer is an outermost layer and may be directly touched by a human hand.

For example, film plating may be performed on the second texture layer, deposits for film plating are SiO₂/Nb₂O₅ or SiO₂/TiO₂ repeated in at least two sets of stacked layers, and a total thickness of film plating layers on the second texture layer ranges from 50 nm to 400 nm.

It should be understood that the second texture layer is matched with the plurality of film plating layers (the sixth film layer, the metal plating layer, and the seventh film layer), so that spatially layered effect and spatial effect of stacking can be visually presented. In this way, the obtained composite material structure or housing is more aesthetic.

With reference to the fifth aspect, in some implementations of the fifth aspect, the manufacturing method further includes: spraying a second coating layer on a side that is of the fiber fabric and that is away from the sixth film layer.

It should be understood that, when the first fiber prepreg and/or the second fiber prepreg are/is colorless and transparent, the second coating layer may be further sprayed. The second coating layer is located on the side that is of the fiber fabric and that is away from the sixth film layer, and the second coating layer is a colored coating layer. It should be understood that the second coating layer mainly serves to shield an electronic component, and can achieve bottoming effect. For example, a base color (of the second coating layer) may be uniform red, white, black, or the like.

According to a sixth aspect, a manufacturing method for a composite material structure is provided, where the manufacturing method includes: obtaining a fiber fabric; transferring a metal foil material onto the fiber fabric through a hot stamping process, to form a hot stamping layer (with a bright pattern); and preimmersing the fiber fabric with the hot stamping layer in resin, to form a first fiber prepreg.

The hot stamping layer is any one of gold, silver, aluminum, indium, nickel, titanium, or chromium. For example, metal foil may be aluminum foil, gold foil, silver foil, indium foil, or the like, and is preferably aluminum foil and indium foil.

It should be understood that, to achieve better bright effect, a thickness of the hot stamping layer may be limited to 0.01 mm to 0.02 mm.

It should be understood that the first fiber prepreg formed in the foregoing manner includes a fiber sheet and resin wrapping the fiber sheet.

For example, a material of the fiber fabric may include any one of the following: glass fiber, basalt fiber, carbon fiber, aramid fiber, ceramic fiber, PET fiber, UHMWPE fiber, PBO fiber, PI fiber, polypropylene fiber, bast and leaf fiber, and bamboo fiber. The fiber fabric may be colored or colorless. The material of the fiber fabric is preferably glass fiber, followed by UHMWPE fiber.

For example, the resin may include at least one of the following: acetate fiber ester, nylon, polyurethane, polycarbonate, poly(methyl methacrylate), polyethylene terephthalate, epoxy resin, acrylic resin, phenolic resin, and silicon resin. In some embodiments, to achieve better visual effect, the resin may be modified resin containing fluorine, and a refractive index of the modified resin containing fluorine ranges from 1.3 to 1.4.

In this embodiment of this application, when the composite material structure is manufactured, the hot stamping metal layer may be formed on a surface of the fiber fabric through the hot stamping process, and bright line effect or shining effect can be formed through high reflection of metal. When the composite material structure is used in a housing and an electronic device, appearance effect of the housing and the electronic device can be enriched, and appearance aesthetics of the housing and the electronic device can be improved.

With reference to the sixth aspect, in some implementations of the sixth aspect, the manufacturing method includes: obtaining one or more first fiber prepregs, and stacking the one or more first fiber prepregs, to form the composite material structure.

With reference to the sixth aspect, in some implementations of the sixth aspect, the manufacturing method further includes: disposing a second fiber prepreg on one side and/or second fiber prepregs on two sides of the first fiber prepreg. The second fiber prepreg is manufactured in an existing manner, and the second fiber prepreg includes a fiber woven fabric and resin wrapping the fiber woven fabric.

It should be understood that, to avoid blocking the first fiber prepreg, a second fiber prepreg above the first fiber prepreg needs to be colorless and transparent. A second fiber prepreg under the first fiber prepreg may be colored or colorless and transparent, which is not limited herein.

For example, a thickness of one layer of second fiber prepreg and a thickness of one layer of first fiber prepreg both range from 0.07 mm to 0.15 mm. In some embodiments, the thickness of one layer of second fiber prepreg and the thickness of one layer of first fiber prepreg both range from 0.08 mm to 0.11 mm. The thickness of the second fiber prepreg and the thickness of the first fiber prepreg are limited, so that the finally obtained composite material structure is within a specific range. Therefore, when the composite material structure is used in the housing, the thickness of the housing is within a specific range, to avoid the housing being excessively thick.

With reference to the sixth aspect, in some implementations of the sixth aspect, the manufacturing method further includes: spraying a first coating layer on a side that is of the hot stamping layer and that is away from the fiber fabric.

For example, the first coating layer includes a first texture layer, a first bonding layer, a second texture layer, and a second bonding layer that are sequentially stacked. The first texture layer is an outer texture layer, the outer texture layer is a surface layer that may be touched by a human hand, and the outer texture layer can enhance a tactile feeling. The second texture layer is an inner texture layer, and cannot be directly touched by a human hand. The first bonding layer and the second bonding layer are transition bonding layers. The first bonding layer is connected between the first texture layer and the second texture layer, and the second bonding layer may be connected to the first fiber prepreg. Therefore, the formed composite material structure may sequentially include the fiber fabric, the plurality of film plating layers, the second bonding layer, the second texture layer, the first bonding layer, and the first texture layer from a bottom layer to a top layer. The fiber fabric is an innermost layer and cannot be directly touched by a human hand, and the first texture layer is an outermost layer and may be directly touched by a human hand.

For example, film plating may be performed on the second texture layer, deposits for film plating are SiO₂/Nb₂O₅ or SiO₂/TiO₂ repeated in at least two sets of stacked layers, and a total thickness of film plating layers on the second texture layer ranges from 50 nm to 400 nm.

It should be understood that the second texture layer is matched with the hot stamping layer, so that spatially layered effect and spatial effect of stacking can be visually presented. In this way, the obtained composite material structure or housing is more aesthetic.

With reference to the sixth aspect, in some implementations of the sixth aspect, the manufacturing method further includes: spraying a second coating layer on a side that is of the fiber fabric and that is away from the hot stamping layer.

It should be understood that, when the first fiber prepreg and/or the second fiber prepreg are/is colorless and transparent, the second coating layer may be further sprayed. The second coating layer is located on the side that is of the fiber fabric and that is away from the hot stamping layer, and the second coating layer is a colored coating layer. It should be understood that the second coating layer mainly serves to shield an electronic component, and can achieve bottoming effect. For example, a base color (of the second coating layer) may be uniform red, white, black, or the like.

According to a seventh aspect, a housing is provided. The housing is manufactured by using the composite material structure according to any one of the first aspect or the implementations of the first aspect, or the housing is manufactured by using the composite material structure according to any one of the second aspect or the implementations of the second aspect, or the housing is manufactured by using the composite material structure according to any one of the third aspect or the implementations of the third aspect.

According to an eighth aspect, an electronic device is provided. The electronic device includes a housing, and the housing is manufactured by using the composite material structure according to any one of the first aspect or the implementations of the first aspect, or the housing is manufactured by using the composite material structure according to any one of the second aspect or the implementations of the second aspect, or the housing is manufactured by using the composite material structure according to any one of the third aspect or the implementations of the third aspect.

In some embodiments, the electronic device further includes a transparent cover that covers the housing. The housing and the transparent cover cooperate to form accommodation space. Elements such as a display module, a touch module, a chip, a battery, and a circuit mainboard of the electronic device are disposed in the accommodation space. A surface that is of the transparent cover and that is away from the housing is a touch display surface of the electronic device.

For example, the electronic device may be an electronic device having a housing, for example, may include a mobile terminal such as a mobile phone, a wearable device, a smartwatch, a tablet computer, an e-reader, a notebook computer, a laptop computer, a mobile computer, an augmented reality device, a virtual reality device, a palmtop game console, or the like. This is not limited in this application.

### BRIEF DESCRIPTION OF DRAWINGS

FIG. 1 is a schematic flowchart of an appearance processing process of a housing according to this application;
FIG. 2 is a cross-sectional diagram of a composite material structure according to an embodiment of this application;
FIG. 3 is a cross-sectional diagram of another composite material structure according to an embodiment of this application;
FIG. 4 is a cross-sectional diagram of another composite material structure according to an embodiment of this application;
FIG. 5 is a diagram of a first fiber prepreg according to an embodiment of this application;
FIG. 6 is a schematic flowchart of an appearance processing process of a housing according to an embodiment of this application;
FIG. 7 is a schematic flowchart of another appearance processing process of a housing according to an embodiment of this application; and
FIG. 8 is a diagram of an electronic device according to an embodiment of this application.

### DESCRIPTION OF EMBODIMENTS

The following describes technical solutions of this application with reference to accompanying drawings.

The terms "first" and "second" in embodiments of this application are merely intended for a purpose of description, and shall not be understood as an indication or implication of relative importance or implicit indication of a quantity of indicated technical features. Therefore, a feature limited by "first " or "second" may explicitly indicate or implicitly include one or more such features. In addition, in the descriptions of embodiments of this application, "a plurality of" means two or more, and "at least one" and "one or more" mean one, two, or more. The singular expression forms "one", "a", "the", "the foregoing", "this", and "the one" are also intended to include an expression form such as "one or more", unless the opposite is explicitly indicated in the context thereof. Sequence numbers of the following processes do not mean an execution sequence. The execution sequence of the processes should be determined based on functions and internal logic of the processes, and should not constitute any limitation on an implementation process of embodiments of this application. For example, in embodiments of this application, the terms "110", "120", "130", and the like are merely identifiers for ease of description, and are not intended to limit an execution sequence of steps. The term "and/or" is used to describe an association relationship between associated objects and represents that three relationships may exist. For example, A and/or B may represent the following cases: Only A exists, both A and B exist, and only B exists, where A and B may be singular or plural. The character "/" generally indicates an "or" relationship between the associated objects.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "comprise", "have", and their variants all mean "include but are not limited to", unless otherwise specifically emphasized.

In the descriptions of embodiments of this application, an orientation or a position relationship indicated by the term "up", "down", or the like is defined relative to an orientation or a position at which a component is schematically placed in the accompanying drawings. It should be understood that these directional terms are relative concepts, and are used for relative description and clarification instead of indicating or implying that a specified apparatus or component needs to have a specific orientation or be constructed and operated in a specific orientation. These direction terms may vary based on changes of positions of the components in the accompanying drawings, and therefore cannot be understood as a limitation on this application.

To highlight high-end quality of an electronic device, an electronic device manufacturer increasingly attaches importance to appearance decoration of a housing of the electronic device. For example, a color may be provided on the housing, so that the electronic device may present a plurality of body colors. For another example, texture may be provided on the housing, so that an appearance of the electronic device may have matte visual effect, frosted visual effect, or the like.

A fiber composite material has characteristics such as high strength and low density. When used as a housing material of an electronic device, the fiber composite material has advantages of being lightweight and not prone to breakage upon falling. Therefore, the fiber composite material is a key housing material for a future electronic device. Due to a molding process of the fiber composite material and characteristics of a composite material, fiber texture is likely to be visible on a housing base, resulting in ordinary perception of quality and poor aesthetics. Especially, when the fiber composite material is used as a rear cover material of high-end products such as a flagship mobile phone and a tablet computer, overall aesthetics and a sense of value of the product are greatly affected.

Currently, an appearance processing process for the housing base is mainly spray coating combined with rubbing, flow coating combined with transfer printing, flow coating combined with rubbing, or the like. However, these conventional processes contribute to merely planar effect, but fail to achieve differentiation. These conventional processes cannot bring richer appearance effect to consumers and improve appearance aesthetics of the product.

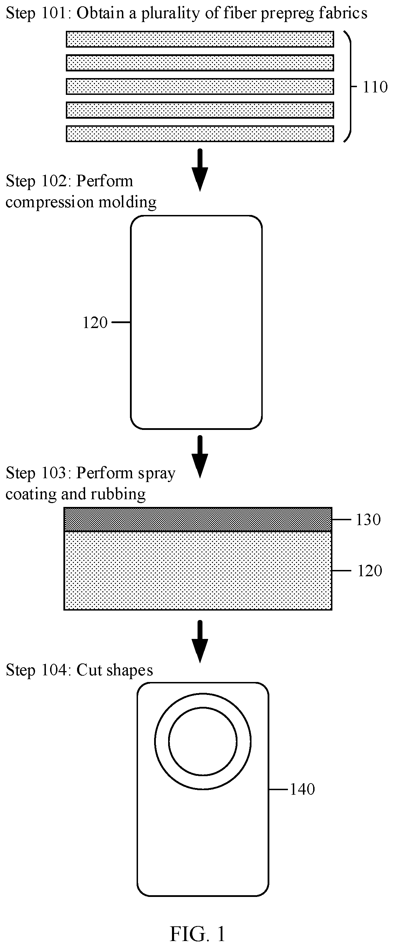

For example, FIG. 1 is a schematic flowchart of an appearance processing process of a housing.

Step 101: Obtain a plurality of fiber prepreg fabrics, where the plurality of fiber prepreg fabrics may be stacked.

The fiber prepreg fabric may also be referred to as a second fiber prepreg 110, and the second fiber prepreg 110 may be understood as a fiber composite material preimpregnated with resin. The fiber composite material herein may be a fiber woven fabric.

For example, the second fiber prepreg 110 may be a fiber woven fabric impregnated with the to-be-cured resin. In other words, the second fiber prepreg 110 may include the fiber woven fabric and the resin wrapping the fiber woven fabric. The resin wrapping the fiber woven fabric may include at least one of the following: acetate fiber ester, nylon, polyurethane, polycarbonate, poly(methyl methacrylate), polyethylene terephthalate, epoxy resin, acrylic resin, phenolic resin, and silicon resin. This is not limited in this application.

For example, the second fiber prepreg 110 may be colored, colorless and translucent, or colorless and transparent, and is preferably colorless and transparent.

For example, the fiber woven fabric is a fabric formed by interlacing fiber by using textile machinery. Different fiber may be used for the fabric. For example, a fiber material (namely, a material of the fiber woven fabric) included in the second fiber prepreg 110 may be any one of the following: glass fiber, basalt fiber, carbon fiber, aramid fiber, ceramic fiber, PET fiber, UHMWPE fiber, PBO fiber, PI fiber, polypropylene fiber, bast and leaf fiber, and bamboo fiber. The material of the fiber woven fabric is preferably glass fiber, followed by UHMWPE fiber.

Step 102: Perform compression molding on the plurality of stacked second fiber prepregs 110, to form a first fiber composite material housing base 120.

Compression molding is a manufacturing process, and is usually used to process a member or a product made of plastic, metal, and another material. In this process, the material is heated to a softened state, then placed into a mold, and subjected to high pressure, so that the material forms a required shape in the mold. Once cooled and solidified, the material remains in the formed shape.

In this step, the plurality of stacked second fiber prepregs 110 may be heated to a softened state, and then placed into a mold, so that the second fiber prepregs 110 form a required shape in the mold, for example, form a shape of the mobile phone housing shown in FIG. 1. Finally, the second fiber prepregs 110 are cooled and solidified, so that the second fiber prepregs 110 form the first fiber composite material housing base 120 (such as a mobile phone housing base).

Step 103: Perform spray coating and rubbing on one surface of the first fiber composite material housing base 120, to form a first coating layer 130.

It should be understood that the first coating layer 130 is sprayed on the surface of the first fiber composite material housing base 120, so that a texture structure of a surface layer can be implemented, and a tactile feeling can be enhanced.

It should be noted that, in step 103, the first coating layer 130 may be formed through spray coating combined with rubbing, or may be formed through flow coating combined with transfer printing, or flow coating combined with rubbing.

Through spray coating combined with rubbing, a pattern or an image may be transferred onto a target surface. In this process, a spray coating technology is first used to apply a coating material evenly to a printing medium in a form of spray. Then, a rubbing technology is used, so that the printing medium is in contact with the target surface, and specific pressure is applied. In this way, the coating material is transferred from the medium onto the target surface, to form a required pattern or image. Flow coating combined with transfer printing is used to transfer the pattern or image from the printing medium onto the target surface. In this process, the image is printed on special transfer paper first, and then the transfer paper is in contact with the target surface (such as ceramics and glass). Specific pressure and heat are applied, so that the pattern is transferred from the transfer paper onto the target surface. Flow coating combined with rubbing is a printing process that combines a flow coating technology and the rubbing technology. In this process, the flow coating technology is first used to coat the coating material evenly on the printing medium. Then, the printing medium is in contact with the target surface, and specific pressure is applied, so that the coating material is transferred from the medium onto the target surface. In this process, the rubbing process may be used to ensure accurate transfer of the pattern.

Step 104: Cut shapes of the first fiber composite material housing base 120 and the first coating layer 130, to form a housing 140.

It should be noted that, a shape of the first fiber composite material housing base 120 formed in step 102 may still differ from a shape of an electronic device housing that actually needs to be produced, and the shape obtained through compression molding is not accurate. Therefore, cutting needs to be further performed based on the final shape. For example, an area in a mobile phone to dispose a camera needs to be hollowed out. After step 104, final formation of the mobile phone housing may be obtained, and the formed housing can be directly assembled to the mobile phone.

It can be learned from the foregoing processing steps that, because a basic material (the second fiber prepregs 110) that forms the housing has single color brightness, and stacked layers formed by the second fiber prepregs are integrated and have a uniform color (for example, pure black or pure white), the finally formed housing presents a monolithic appearance, which restricts an ability to achieve richer effect, hinders implementation of differentiation, and fails to provide consumers with richer appearance effect and improve appearance aesthetics of a product.

Therefore, this application provides a composite material structure, a housing, and an electronic device. A bright line or a dazzling light sense can be implemented by using the composite material structure. When the composite material structure is used in the housing and the electronic device, appearance effect of the housing and the electronic device can be enriched, and appearance aesthetics of the housing and the electronic device can be improved.

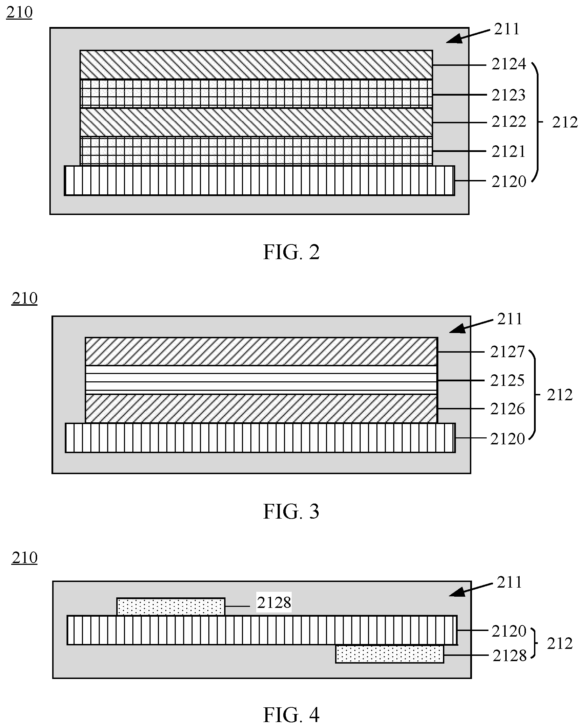

FIG. 2 to FIG. 5 are cross-sectional diagrams of three composite material structures according to embodiments of this application.

The composite material structure provided in this application may include at least one layer of first fiber prepreg 210. The first fiber prepreg 210 may include fiber sheets 212 and resin 211 wrapping the fiber sheet. The first fiber prepreg 210 may be understood as a fiber material preimpregnated with the resin. The fiber material herein may be the fiber sheet 212 in this application. The first fiber prepreg 210 may be a fiber prepreg sheet with brightening effect.

It should be understood that the fiber sheet 212 may be formed on a surface of a fiber fabric 2120 through a film plating process, or may be formed through a hot stamping process.

In some embodiments, as shown in FIG. 2, the fiber sheet 212 includes the fiber fabric 2120 and a plurality of film plating layers located on the surface of the fiber fabric 2120, and a difference between refractive indexes of two adjacent layers of the plurality of film plating layers is greater than or equal to 0.4. The fiber fabric 2120 may be a woven fabric, or may be a mesh fabric, a felt fabric, or the like. The fiber fabric 2120 may be colored or colorless.

For example, the fiber sheet 212 includes the fiber fabric 2120 and the plurality of film plating layers located on the surface of the fiber fabric. The plurality of film plating layers located on the surface of the fiber fabric may also be referred to as an effect layer (an effect layer having brightening effect), and the effect layer may be obtained through film plating. In other words, some colored film plating layers or brightening reflective effect layers may be plated on the fiber fabric 2120, so that the finally obtained composite material structure can present a bright line or a colored dazzling light sense.

In this embodiment, the difference between the refractive indexes of two adjacent layers of the plurality of film plating layers in the composite material structure is limited to 0.4 or more, that is, a material with a low refractive index and a material with a high refractive index are sequentially and repeatedly stacked, so that bright line effect or bright sheet effect can be formed based on a difference in brightness formed due to a difference between refractive indexes. When the composite material structure is used in a housing and an electronic device, appearance effect of the housing and the electronic device can be enriched, and appearance aesthetics of the housing and the electronic device can be improved.

For example, as shown in FIG. 2, the plurality of film plating layers may include a plurality of first plating layers and a plurality of second plating layers that are alternately stacked, and a total thickness of the first plating layers and the second plating layers ranges from 600 nm to 2000 nm. That is, a total thickness of the plurality of film plating layers ranges from 600 nm to 2000 nm. For example, the first plating layer may be in contact with the fiber fabric 2120. That is, the fiber fabric is first plated with a first film layer 2121, then plated with a second film layer 2122, then plated with a third film layer 2123, and then plated with a fourth film layer 2124 for sequential stacking. The first film layer 2121 and the third film layer 2123 are the first plating layers, and the second film layer 2122 and the fourth film layer 2124 are the second plating layers.

It should be understood that the thickness of the plurality of film plating layers is limited to a proper range, so that bright line effect or bright sheet effect presented by the effect layer is better. In addition, reliability of the film plating layer is higher, and manufacturing costs are reduced accordingly.

For example, the first plating layer may be any one of silicon dioxide (SiO₂), zirconium dioxide (ZrO₂), or monocrystalline silicon, and the second plating layer may be any one of niobium pentoxide (Nb₂O₅), titanium dioxide (TiO₂), or silicon nitride (Si₃N₄).

For example, the plurality of film plating layers may include SiO₂/Nb₂O₅ repeated in at least two sets of stacked layers, or SiO₂/TiO₂ repeated in at least two sets of stacked layers. That is, the plurality of film plating layers may include at least four stacked layers, which may be SiO₂/Nb₂0₅/SiO₂/Nb₂O₅ stacked layers or SiO₂/TiO₂/SiO₂/TiO₂ stacked layers, and a difference between refractive indexes of two adjacent layers is greater than or equal to 0.4.

In some examples, to achieve better bright line visual effect or bright sheet visual effect, a fifth film layer may be disposed on a side that is of the fourth plating layer 2124 and that is away from the fiber fabric 2120. In other words, the plurality of film plating layers may include five stacked layers, which may be SiO₂/Nb₂O₅/SiO₂/Nb₂O₅/SiO₂ stacked layers or SiO₂/TiO₂/SiO₂/TiO₂/SiO₂ stacked layers, and a difference between refractive indexes of two adjacent layers is greater than or equal to 0.4.

For example, in this embodiment of this application, deposits may be deposited on the surface (one surface or two surfaces) of the fiber fabric in a vacuum physical deposition manner, for example, deposited on a surface of glass fiber in the vacuum physical deposition manner. The deposits may be SiO₂/Nb₂O₅ or SiO₂/TiO₂ repeated in at least two sets of stacked layers.

In some embodiments, as shown in FIG. 3, the fiber sheet 212 includes the fiber fabric 2120 and a plurality of film plating layers located on the surface of the fiber fabric 2120. The plurality of film plating layers include a metal plating layer 2125 and third plating layers (where the third plating layer includes a sixth film layer 2126 and a seventh film layer 2127) disposed on two sides of the metal plating layer. The fiber fabric 2120 may be a woven fabric, or may be a mesh fabric, a felt fabric, or the like. The fiber fabric 2120 may be colored or colorless.

In this embodiment, the plurality of film plating layers in the composite material structure may include the metal plating layer. In other words, the metal plating layer may be plated on the surface of the fiber fabric. Because the metal plating layer has high reflectivity, bright line effect or shining effect can be formed through reflection of a metal component. When the composite material structure is used in the housing and the electronic device, appearance effect of the housing and the electronic device can be enriched, and appearance aesthetics of the housing and the electronic device can be improved.

For example, the metal plating layer 2125 may be any one of gold, silver, aluminum, indium, nickel, titanium, or chromium, and the third plating layer may be any one of silicon dioxide, zirconium dioxide, or monocrystalline silicon.

It should be understood that the metal plating layer 2125 may be made of a metal material with high reflectivity, such as gold, silver, aluminum, indium, nickel, titanium, or chromium. In addition, the third plating layers are located on the two sides of the metal plating layer 2125. The third plating layer is a stable material, such as silicon dioxide, zirconium dioxide, or monocrystalline silicon. The third plating layer can protect the metal plating layer, and can prevent corrosion, oxidation, or the like on the metal plating layer 2125.

For example, as shown in FIG. 3, the plurality of film plating layers may include three stacked layers, which sequentially include the sixth film layer 2126, the metal plating layer 2125, and the seventh film layer 2127, and the sixth film layer 2126 is in contact with the fiber fabric 2120. For example, the plurality of film plating layers may include SiO₂/In/SiO₂ stacked layers. That is, the plurality of film plating layers may include three stacked layers, which may sequentially be a silicon dioxide layer, an indium layer, and a silicon dioxide layer. The silicon dioxide layer is in contact with the fiber fabric 2120.

In this embodiment of this application, deposits may be deposited on the surface (one surface or two surfaces) of the fiber fabric 2120 in a vacuum physical deposition manner, for example, deposited on a surface of glass fiber in the vacuum physical deposition manner. The deposits may be SiO₂/In/SiO₂ stacked layers.

For example, a total thickness of the plurality of film plating layers ranges from 50 nm to 400 nm. That is, a total thickness of the metal plating layer 2125, the sixth film layer 2126, and the seventh film layer 2127 ranges from 50 nm to 400 nm. A thickness of the metal plating layer 2125 ranges from 2 nm to 20 nm.

It should be understood that the thicknesses of the plurality of film plating layers and the metal plating layer 2125 are limited to proper ranges, so that bright line effect or bright sheet effect presented by the effect layer is better. In addition, reliability of the film plating layer is higher, and manufacturing costs are reduced accordingly.

In some embodiments, as shown in FIG. 4, the fiber sheet 212 includes the fiber fabric 2120 and a hot stamping layer 2128 located on the surface of the fiber fabric 2120. The hot stamping layer 2128 is formed on the surface of the fiber fabric 2120 through a hot stamping process.

It should be understood that, in the hot stamping process, an aluminum layer in electroplated aluminum is transferred onto a surface of a printing substrate according to a hot-press transfer principle, to form special metal effect.

In this embodiment, the composite material structure may include the hot stamping layer. The hot stamping layer may be formed on the surface of the fiber fabric through the hot stamping process. Metal is hot-stamped on the surface of the fiber fabric, so that bright line effect or shining effect is formed through high reflection of a metal component. When the composite material structure is used in the housing and the electronic device, appearance effect of the housing and the electronic device can be enriched, and appearance aesthetics of the housing and the electronic device can be improved.

For example, the hot stamping layer 2128 may be transferred onto one surface of the fiber fabric 2120 through the hot stamping process, or the hot stamping layer 2128 may be transferred onto both surfaces of the fiber fabric 2120 through the hot stamping process. In other words, a metal foil material may be transferred onto the fiber fabric (such as glass fiber fabric) through the hot stamping process, to form a bright pattern. The metal foil material may be transferred onto one surface or both surfaces. Metal foil may be aluminum foil, gold foil, silver foil, indium foil, or the like, and is preferably aluminum foil and indium foil.

For example, the hot stamping layer 2128 may include any one of the following: gold, silver, aluminum, indium, nickel, titanium, and chromium.

For example, a thickness of the hot stamping layer 2128 ranges from 0.01 mm to 0.02 mm. It should be understood that the thickness of the hot stamping layer 2128 is limited to a proper range, so that bright line effect or bright sheet effect presented by the effect layer is better. In addition, reliability of the hot stamping layer 2128 is higher, and manufacturing costs are reduced accordingly.

In some examples, the resin 211 wrapping the fiber sheet may include at least one of the following: acetate fiber ester, nylon, polyurethane, polycarbonate, poly(methyl methacrylate), polyethylene terephthalate, epoxy resin, acrylic resin, phenolic resin, and silicon resin.

For example, the resin 211 wrapping the fiber sheet may be modified resin containing fluorine, and a refractive index of the modified resin containing fluorine ranges from 1.3 to 1.4.

It should be understood that the impregnated resin 211 in the first fiber prepreg 210 may be resin containing fluorine, and the refractive index of the impregnated resin ranges from 1.3 to 1.4, and is less than a refractive index of conventional resin (the refractive index of the conventional resin ranges approximately from 1.5 to 1.6). When observing the composite material structure, a human eye first sees air, then the resin, and finally the effect layer. If the refractive index of the resin is high, effect of the seen effect layer is greatly reduced. If the refractive index of the resin is low, the bright lines or bright sheets of the effect layer are more clear in visual effect, and present effect is better.

In addition, if the resin containing fluorine is not used, to maintain good visual effect, the thickness of the film plating layers needs to be large (for example, 2000 nm). A thicker film plating layer may cause a reliability risk and increase costs. If the resin containing fluorine is used, the thickness of the film plating layers can be reduced to 1200 nm or even 1000 nm. In this way, a problem of thick film plating of the effect layer can be further resolved, to reduce reliability and mass production risks, and reduce costs.

In some examples, a material of the fiber fabric 2120 may include any one of the following: glass fiber, basalt fiber, carbon fiber, aramid fiber, ceramic fiber, PET fiber, UHMWPE fiber, PBO fiber, PI fiber, polypropylene fiber, bast and leaf fiber, and bamboo fiber. The material of the fiber fabric 2120 is preferably glass fiber, followed by UHMWPE fiber.

It should be noted that bright lines or bright sheets in the three structures shown in FIG. 2 may be ordered or unordered. This is not limited in this application. For example, regular bright lines or bright sheets may be manufactured and formed according to an actual requirement, or unordered bright lines or bright sheets may be manufactured and formed.

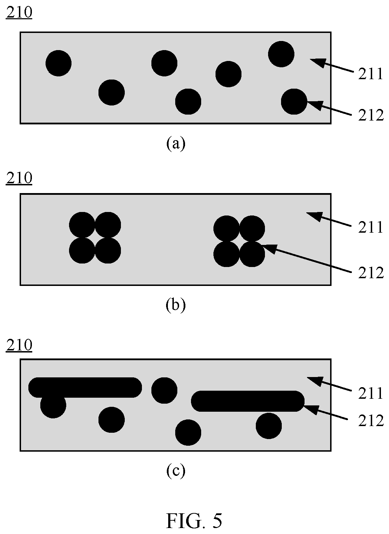

For example, FIG. 5 is a schematic top view of the first fiber prepreg 210. The first fiber prepreg 210 may include the to-be-cured resin 211 and the fiber sheets 212, and the fiber sheets 212 may be ordered or unordered.

In an example, as shown in (a) in FIG. 5, the fiber sheets 212 may be arranged unidirectionally, and may form unordered bright effect.

In an example, as shown in (b) in FIG. 5, the fiber sheets 212 may be arranged in bundles, and may form ordered bright effect.

In an example, as shown in (c) in FIG. 5, the fiber sheets 212 may be arranged multidirectionally, and may form bright lines.

In some examples, the composite material structure may further include at least one layer of second fiber prepreg 110 stacked with the first fiber prepreg 210, and the second fiber prepreg 110 includes a fiber woven fabric and resin wrapping the fiber woven fabric.

The second fiber prepreg 110 may be understood as a fiber composite material preimpregnated with resin. The fiber composite material herein may be a fiber woven fabric. Therefore, the second fiber prepreg may also be referred to as a fiber prepreg fabric.

It should be noted that, the second fiber prepreg 110 is a fiber woven fabric impregnated with to-be-cured resin, and the first fiber prepreg 210 is a fiber sheet impregnated with the to-be-cured resin. A main difference between the first fiber prepreg 210 and the second fiber prepreg 110 lies in impregnated-layer materials in the to-be-cured resin. An impregnated material of the second fiber prepreg 110 is the fiber woven fabric, and an impregnated material of the first fiber prepreg 210 is the fiber sheet provided in this application. The fiber sheet includes the plurality of film plating layers or the hot stamping layer, and the plurality of film plating layers or the hot stamping layer can achieve brightening effect.

For example, a quantity of stacked layers included by the composite material structure ranges from two to eight, and preferably, the quantity of stacked layers may range from two to five. The first fiber prepreg 210 may be at any layer, preferably at any one of first to third layers, and remaining stacked layers may be second fiber prepregs 110.

It should be understood that, to avoid blocking the first fiber prepreg 210, a second fiber prepreg 110 above the first fiber prepreg 210 needs to be colorless and transparent. A second fiber prepreg 110 under the first fiber prepreg 210 may be colored or colorless and transparent, which is not limited herein.

It should be noted that, for related descriptions of the second fiber prepreg 110, refer to related descriptions in FIG. 1.

In some examples, a thickness of one layer of second fiber prepreg 110 and/or a thickness of one layer of first fiber prepreg 210 range/ranges from 0.07 mm to 0.15 mm. In some embodiments, the thickness of one layer of second fiber prepreg 110 and/or the thickness of one layer of first fiber prepreg 210 may range from 0.08 mm to 0.11 mm. The thickness of one layer of second fiber prepreg 110 and/or the thickness of one layer of first fiber prepreg 210 are/is limited, so that the finally obtained composite material structure is within a specific range. Therefore, when the composite material structure is used in the housing, a thickness of the housing is within a specific range, to avoid the housing being excessively thick.

In some examples, to present good visual effect, fiber (namely, fiber filaments) forming the fiber fabric should not be excessively thick, and a maximum cross-sectional width of the fiber (namely, fiber filaments) forming the fiber fabric ranges from 1 µm to 30 µm.Optionally, to present higher visual effect, the maximum cross-sectional width of the fiber forming the fiber fabric may range from 3 µm to 10 µm.

For example, a cross section of the fiber (namely, fiber filaments) that forms the fiber fabric may be solid or hollow. When the cross section is of a hollow structure, an annular bright line may be formed.

For example, a shape of the cross section of the fiber (namely, fiber filaments) that forms the fiber fabric may be one of a circle, a square, or a polygon.

In some examples, the composite material structure may further include a first coating layer, and the first coating layer is located on a side that is of the plurality of film plating layers and that is away from the fiber fabric 2120. For example, the first coating layer includes a first texture layer, a first bonding layer, a second texture layer, and a second bonding layer that are sequentially stacked. The first texture layer is an outer texture layer, the outer texture layer is a surface layer that may be touched by a human hand, and the outer texture layer can enhance a tactile feeling. The second texture layer is an inner texture layer, and cannot be directly touched by a human hand. The first bonding layer and the second bonding layer are transition bonding layers. The first bonding layer is connected between the first texture layer and the second texture layer, and the second bonding layer may be connected to the first fiber prepreg 210, to form the composite material structure. For example, the formed composite material structure may sequentially include the fiber fabric 2120, the plurality of film plating layers, the second bonding layer, the second texture layer, the first bonding layer, and the first texture layer from a bottom layer to a top layer. The fiber fabric 2120 is an innermost layer and cannot be directly touched by a human hand, and the first texture layer is an outermost layer and may be directly touched by a human hand.

For example, film plating may be performed on the second texture layer, deposits for film plating are SiO₂/Nb₂O₅ or SiO₂/TiO₂ repeated in at least two sets of stacked layers, and a total thickness of film plating layers on the second texture layer ranges from 50 nm to 400 nm.

It should be understood that the second texture layer is matched with the first fiber prepreg 210 provided in this application, or the second texture layer is matched with the plurality of film plating layers or the hot stamping layer provided in this application, so that spatially layered effect and spatial effect of stacking can be visually presented. In this way, the obtained composite material structure or housing is more aesthetic.

In some examples, when the first fiber prepreg 210 and/or the second fiber prepreg 110 are/is colorless and transparent, the composite material structure may further include a second coating layer. The second coating layer is located on a side that is of the fiber fabric 2120 and that is away from the plurality of film plating layers, and the second coating layer is a colored coating layer. It should be understood that the second coating layer mainly serves to shield an electronic component, and can achieve bottoming effect. For example, a base color (of the second coating layer) may be uniform red, white, black, or the like.

The foregoing describes the three composite material structures provided in embodiments of this application with reference to FIG. 2 to FIG. 5. For the foregoing composite material structures, embodiments of this application further provide corresponding manufacturing methods for the composite material structures.

In an implementation, this application provides a manufacturing method 1 for a composite material structure: obtaining a fiber fabric 2120; disposing a plurality of film plating layers on a surface of the fiber fabric 2120 through a film plating process, where a difference between refractive indexes of two adjacent layers of the plurality of film plating layers is greater than or equal to 0.4; and preimmersing the fiber fabric with the plurality of film plating layers in resin 211, to form a first fiber prepreg 210.

In some embodiments, the manufacturing method 1 may further include: obtaining one or more first fiber prepregs 210, and stacking the one or more first fiber prepregs 210, to form the composite material structure.

In some embodiments, disposing the plurality of film plating layers on the surface of the fiber fabric through the film plating process may specifically include: plating a first film layer 2121 on the surface of the fiber fabric 2120; plating a second film layer 2122 on a surface that is of the first film layer 2121 and that is away from the fiber fabric 2120; plating a third film layer 2123 on a surface that is of the second film layer 2122 and that is away from the fiber fabric 2120; and plating a fourth film layer 2124 on a surface that is of the third film layer 2123 and that is away from the fiber fabric 2120. It should be understood that the plurality of film plating layers include the first film layer 2121, the second film layer 2122, the third film layer 2123, and the fourth film layer 2124.

For example, to achieve better bright line visual effect, a fifth film layer may be further plated on a surface that is of the fourth film layer 2124 and that is away from the fiber fabric 2120. It should be understood that the plurality of film plating layers may include the first film layer 2121, the second film layer 2122, the third film layer 2123, the fourth film layer 2124, and the fifth film layer.

The first film layer 2121, the third film layer 2123, and the fifth film layer are the foregoing first plating layers, and the second film layer 2122 and the fourth film layer 2124 are the foregoing second plating layers. For example, the first plating layer may be any one of silicon dioxide, zirconium dioxide, or monocrystalline silicon, and the second plating layer may be any one of niobium pentoxide, titanium dioxide, or silicon nitride.

In some embodiments, the manufacturing method 1 may further include: disposing a second fiber prepreg 110 on one side and/or second fiber prepregs 110 on two sides of the first fiber prepreg 210. For specific descriptions of the second fiber prepreg 110, refer to related descriptions in FIG. 1.

It should be understood that, to avoid blocking the first fiber prepreg 210, a second fiber prepreg 110 above the first fiber prepreg 210 may be colorless and transparent. A second fiber prepreg 110 under the first fiber prepreg 210 may be colored or colorless and transparent, which is not limited herein.

In some embodiments, the manufacturing method 1 may further include: spraying a first coating layer on a side that is of the plurality of film plating layers (or the fourth film layer 2124) and that is away from the fiber fabric 2120.

For example, for the first coating layer, refer to the first coating layer 130 in FIG. 1, FIG. 6, and FIG. 7.

It should be understood that the first coating layer may include a first texture layer, a first bonding layer, a second texture layer, and a second bonding layer that are sequentially stacked. The first texture layer is an outer texture layer, the outer texture layer is a surface layer that may be touched by a human hand, and the outer texture layer can enhance a tactile feeling. The second texture layer is an inner texture layer, and cannot be directly touched by a human hand. The first bonding layer and the second bonding layer are transition bonding layers. The first bonding layer is connected between the first texture layer and the second texture layer, and the second bonding layer may be connected to the first fiber prepreg 210. Therefore, the formed composite material structure may sequentially include the fiber fabric 2120, the plurality of film plating layers, the second bonding layer, the second texture layer, the first bonding layer, and the first texture layer from a bottom layer to a top layer. The fiber fabric 2120 is an innermost layer and cannot be directly touched by a human hand, and the first texture layer is an outermost layer and may be directly touched by a human hand.

It should be understood that the second texture layer is matched with the plurality of film plating layers, so that spatially layered effect and spatial effect of stacking can be visually presented. In this way, the obtained composite material structure or housing is more aesthetic.

In some embodiments, the manufacturing method 1 may further include: spraying a second coating layer on a side that is of the fiber fabric 2120 and that is away from the plurality of film plating layers (or the first film layer 2121).

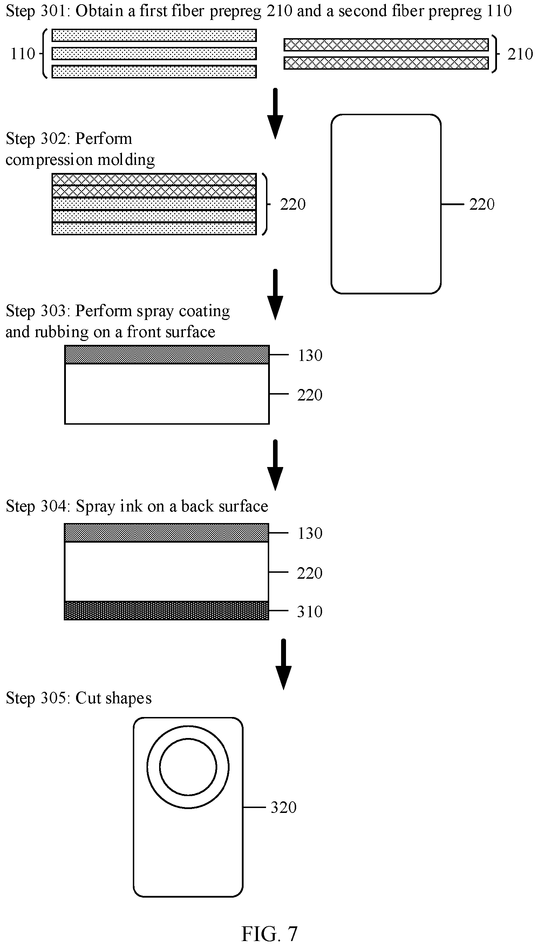

For example, for the second coating layer, refer to the second coating layer 310 in FIG. 7.

It should be understood that, when the first fiber prepreg 210 and/or the second fiber prepreg 110 are/is colorless and transparent, the second coating layer may be further sprayed. The second coating layer is located on the side that is of the fiber fabric 2120 and that is away from the plurality of film plating layers (or the first film layer 2121), and the second coating layer is a colored coating layer. It should be understood that the second coating layer mainly serves to shield an electronic component, and can achieve bottoming effect. For example, a base color (of the second coating layer) may be uniform red, white, black, or the like.

It should be noted that the composite material structure shown in FIG. 2 may be obtained according to the manufacturing method 1 for a composite material structure.

In another implementation, this application provides a manufacturing method 2 for a composite material structure: obtaining a fiber fabric 2120; plating a sixth film layer 2126 on a surface of the fiber fabric 2120 through a film plating process; plating a metal plating layer 2125 on a side that is of the sixth film layer 2126 and that is away from the fiber fabric 2120 through the film plating process; and plating a seventh film layer 2127 on a side that is of the metal plating layer 2125 and that is away from the fiber fabric 2120 through the film plating process; and preimmersing the fiber fabric 2120 with a plurality of plating layers (where the plurality of plating layers include the sixth film layer 2126, the metal plating layer 2125, and the seventh film layer 2127) in resin 211, to form a first fiber prepreg 210.

Both the sixth film layer 2126 and the seventh film layer 2127 are the foregoing third plating layers. For example, the third plating layer may be any one of silicon dioxide, zirconium dioxide, or monocrystalline silicon, and the metal plating layer 2125 may be any one of gold, silver, aluminum, indium, nickel, titanium, or chromium.

In some embodiments, the manufacturing method 2 may include: obtaining one or more first fiber prepregs 210, and stacking the one or more first fiber prepregs 210, to form the composite material structure.

In some embodiments, the manufacturing method 2 may further include: disposing a second fiber prepreg 110 on one side and/or second fiber prepregs 110 on two sides of the first fiber prepreg 210. The second fiber prepreg 110 is manufactured in an existing manner. For specific descriptions of the second fiber prepreg 110, refer to related descriptions in FIG. 1.

It should be understood that, to avoid blocking the first fiber prepreg 210, a second fiber prepreg 110 above the first fiber prepreg 210 needs to be colorless and transparent. A second fiber prepreg 110 under the first fiber prepreg 210 may be colored or colorless and transparent, which is not limited herein.

In some embodiments, the manufacturing method 2 may further include: spraying a first coating layer on a side that is of the plurality of film plating layers (or the seventh film layer 2127) and that is away from the fiber fabric 2120.

For example, for the first coating layer, refer to the first coating layer 130 in FIG. 1, FIG. 6, and FIG. 7.

It should be understood that the first coating layer may include a first texture layer, a first bonding layer, a second texture layer, and a second bonding layer that are sequentially stacked. The first texture layer is an outer texture layer, the outer texture layer is a surface layer that may be touched by a human hand, and the outer texture layer can enhance a tactile feeling. The second texture layer is an inner texture layer, and cannot be directly touched by a human hand. The first bonding layer and the second bonding layer are transition bonding layers. The first bonding layer is connected between the first texture layer and the second texture layer, and the second bonding layer may be connected to the first fiber prepreg. Therefore, the formed composite material structure may sequentially include the fiber fabric, the plurality of film plating layers, the second bonding layer, the second texture layer, the first bonding layer, and the first texture layer from a bottom layer to a top layer. The fiber fabric is an innermost layer and cannot be directly touched by a human hand, and the first texture layer is an outermost layer and may be directly touched by a human hand.

It should be understood that the second texture layer is matched with the plurality of film plating layers, so that spatially layered effect and spatial effect of stacking can be visually presented. In this way, the obtained composite material structure or housing is more aesthetic.

In some embodiments, the manufacturing method 2 may further include: spraying a second coating layer on a side that is of the fiber fabric 2120 and that is away from the plurality of film plating layers (or the sixth film layer 2126).

For example, for the second coating layer, refer to the second coating layer 310 in FIG. 7.

It should be understood that, when the first fiber prepreg 210 and/or the second fiber prepreg 110 are/is colorless and transparent, the second coating layer may be further sprayed. The second coating layer is located on the side that is of the fiber fabric 2120 and that is away from the plurality of film plating layers (or the sixth film layer 2126), and the second coating layer is a colored coating layer. It should be understood that the second coating layer mainly serves to shield an electronic component, and can achieve bottoming effect. For example, a base color (of the second coating layer) may be uniform red, white, black, or the like.

It should be noted that the composite material structure shown in FIG. 3 may be obtained according to the manufacturing method 2 for a composite material structure.

In still another implementation, this application provides a manufacturing method 3 for a composite material structure: obtaining a fiber fabric 2120; transferring a metal foil material onto the fiber fabric 2120 through a hot stamping process, to form a hot stamping layer 2128 (with a bright pattern); and preimmersing the fiber fabric with the hot stamping layer 2128 in resin 211, to form a first fiber prepreg 210.

The hot stamping layer 2128 may be any one of gold, silver, aluminum, indium, nickel, titanium, or chromium. For example, metal foil may be aluminum foil, gold foil, silver foil, indium foil, or the like, and is preferably aluminum foil and indium foil.

It should be understood that, to achieve better bright effect, a thickness of the hot stamping layer may be limited to 0.01 mm to 0.02 mm.

In some embodiments, the manufacturing method 3 may include: obtaining one or more first fiber prepregs 210, and stacking the one or more first fiber prepregs 210, to form the composite material structure.

In some embodiments, the manufacturing method 3 may further include: disposing a second fiber prepreg 110 on one side and/or second fiber prepregs 110 on two sides of the first fiber prepreg 210. The second fiber prepreg 110 is manufactured in an existing manner. For specific descriptions of the second fiber prepreg 110, refer to related descriptions in FIG. 1.

It should be understood that, to avoid blocking the first fiber prepreg 210, a second fiber prepreg 110 above the first fiber prepreg 210 needs to be colorless and transparent. A second fiber prepreg 110 under the first fiber prepreg 210 may be colored or colorless and transparent, which is not limited herein.

In some embodiments, the manufacturing method 3 may further include: spraying a first coating layer on a side that is of the hot stamping layer 2128 and that is away from the fiber fabric 2120.

For example, for the first coating layer, refer to the first coating layer 130 in FIG. 1, FIG. 6, and FIG. 7.

It should be understood that the first coating layer may include a first texture layer, a first bonding layer, a second texture layer, and a second bonding layer that are sequentially stacked. The first texture layer is an outer texture layer, the outer texture layer is a surface layer that may be touched by a human hand, and the outer texture layer can enhance a tactile feeling. The second texture layer is an inner texture layer, and cannot be directly touched by a human hand. The first bonding layer and the second bonding layer are transition bonding layers. The first bonding layer is connected between the first texture layer and the second texture layer, and the second bonding layer may be connected to the first fiber prepreg 210. Therefore, the formed composite material structure may sequentially include the fiber fabric 2120, the hot stamping layer 2128, the second bonding layer, the second texture layer, the first bonding layer, and the first texture layer from a bottom layer to a top layer. The fiber fabric is an innermost layer and cannot be directly touched by a human hand, and the first texture layer is an outermost layer and may be directly touched by a human hand.

It should be understood that the second texture layer is matched with the plurality of film plating layers, so that spatially layered effect and spatial effect of stacking can be visually presented. In this way, the obtained composite material structure or housing is more aesthetic.

In some embodiments, the manufacturing method 3 may further include: spraying a second coating layer on a side that is of the fiber fabric 2120 and that is away from the first coating layer.

For example, for the second coating layer, refer to the second coating layer 310 in FIG. 7.

It should be understood that, when the first fiber prepreg 210 and/or the second fiber prepreg 110 are/is colorless and transparent, the second coating layer may be further sprayed. The second coating layer is located on the side that is of the fiber fabric 2120 and that is away from the first coating layer, and the second coating layer is a colored coating layer. It should be understood that the second coating layer mainly serves to shield an electronic component, and can achieve bottoming effect. For example, a base color (of the second coating layer) may be uniform red, white, black, or the like.

It should be noted that the composite material structure shown in FIG. 4 may be obtained according to the manufacturing method 3 for a composite material structure.

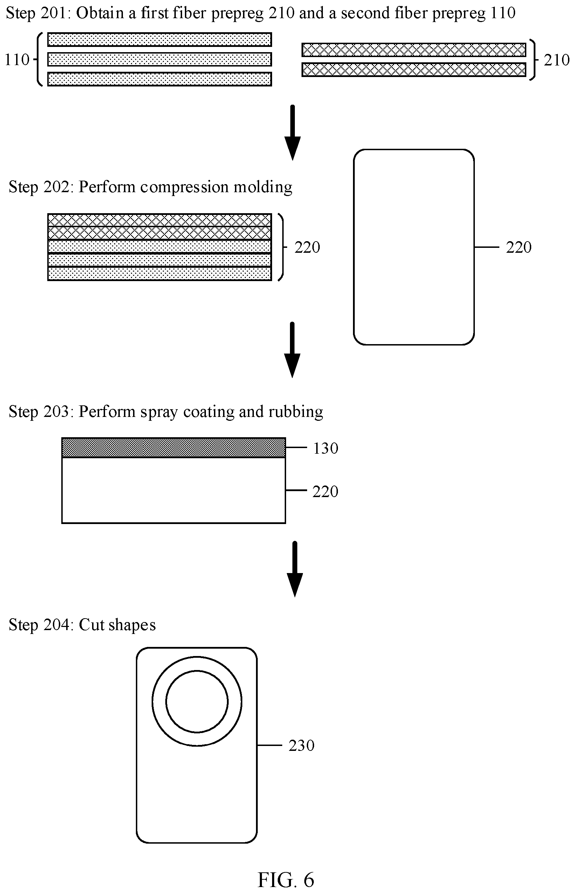

Based on the foregoing descriptions, this application further provides a housing. The housing may include the composite material structure shown in FIG. 2 to FIG. 4. That is, the housing may be manufactured by processing the composite material structure shown in FIG. 2 to FIG. 4. The composite material structure may be manufactured according to the manufacturing method 1 to the manufacturing method 3. The following describes, with reference to FIG. 6 and FIG. 7, an example of a processing method of the housing provided in this application.

FIG. 6 is a schematic flowchart of an appearance processing process of a housing according to an embodiment of this application.

Step 201: Obtain a first fiber prepreg 210 and a second fiber prepreg 110.

There may be one or more first fiber prepregs 210 and second fiber prepregs 110. In this embodiment, an example in which there are three second fiber prepregs 110 and two first fiber prepregs 210 is used for description.

It should be noted that, for related descriptions of the second fiber prepreg 110, refer to related descriptions in FIG. 1, and for related descriptions of the first fiber prepreg 210, refer to related descriptions in FIG. 2 to FIG. 5.

Step 202: Perform compression molding on the first fiber prepreg 210 and the second fiber prepreg 110 that are stacked, to form a second fiber composite material housing base 220.

In this step, the second fiber prepreg 110 and the first fiber prepreg 210 are stacked to form a stacked sheet, where a quantity of layers of the stacked sheet may range from 2 to 8, and preferably range from 2 to 5. The first fiber prepreg 210 may be located at any layer of the stacked sheet, preferably at one of first to third layers of the stacked sheet.

It should be understood that a second fiber prepreg 110 above the first fiber prepreg 210 is colorless and transparent, to prevent a case in which the second fiber prepreg 110 at an upper layer blocks the first fiber prepreg 210 at a lower layer and consequently bright and spatially layered effect of the housing cannot be observed. A second fiber prepreg 110 under the first fiber prepreg 210 may be colored, or may be colorless and transparent. This is not limited in this application.

In this step, the second fiber prepreg 110 and the first fiber prepreg 210 that are stacked may be heated to a softened state, and then placed into a mold, so that the second fiber prepreg 110 and the first fiber prepreg 210 form a required shape in the mold, for example, form a shape of the mobile phone housing shown in FIG. 2. Finally, the second fiber prepreg 110 and the first fiber prepreg 210 are cooled and solidified, so that the second fiber prepreg 110 and the first fiber prepreg 210 form the second fiber composite material housing base 220 (such as a mobile phone housing base).

For other content in this step, refer to step 102, and details are not described herein again.

Step 203: Perform spray coating and rubbing on one surface of the second fiber composite material housing base 220, to form a first coating layer 130.

For example, the sprayed first coating layer 130 includes at least four layers. Rubbing of a first layer of texture (namely, outer texture) is performed on a first layer, and the outer texture is used to enhance a tactile feeling when the outer texture is touched by a human hand. Rubbing of a second layer of texture (namely, inner texture) is performed on a third layer, and the inner texture can be matched with a fiber sheet 212 to produce stacking effect, to have spatially layered effect. Film plating is performed on the second layer of texture. The first layer and the third layer are colorless and transparent, and the second layer and a fourth layer are colored and translucent or colorless and transparent. Deposits for film plating may be SiO₂/Nb₂O₅ or SiO₂/TiO₂ repeated in at least two sets of stacked layers, and a total thickness of the deposits ranges from 50 nm to 400 nm.

Step 204: Cut shapes of a first fiber composite material housing base 120 and the first coating layer 130, to form a first housing 230.

For specific content of step 203 and step 204, refer to step 103 and step 104 respectively, and details are not described herein again.

In this embodiment of this application, the first fiber prepreg 210 is added. That is, in a multi-layer stacked sheet structure, a composite structure of an effect fiber layer and a rubbed-texture layer is used, to achieve spatial effect of a rear cover made of a fiber composite material, improve appearance aesthetics of the fiber composite material used in the rear cover, and form differentiated effect.

FIG. 7 is a schematic flowchart of another appearance processing process of a housing according to an embodiment of this application.

Step 301: Obtain a first fiber prepreg 210 and a second fiber prepreg 110.

Step 302: Stack the first fiber prepreg 210 and the second fiber prepreg 110, and perform compression molding, to form a second fiber composite material housing base 220.

Step 303: Perform spray coating and rubbing on one surface of the second fiber composite material housing base 220, to form a first coating layer 130.

For specific content of step 301 to step 303, refer to step 201 to step 203, and details are not described herein again.

Step 304: Spray ink on the other surface of the second fiber composite material housing base 220, to form a second coating layer 310.

It should be noted that, when both the first coating layer 130 and the second fiber composite material housing base 220 are colorless and transparent, ink may be sprayed on a surface that is of the second fiber composite material housing base 220 and that is away from the first coating layer 130, to form the second coating layer 310 (where the second coating layer 310 is a colored coating layer), to implement shielding and bottoming functions.

The surface on which the first coating layer 130 is formed is a front surface of the housing, which is visible to a user. A surface on which the second coating layer 310 is formed is a back surface of the housing, which is not visible to the user.

Step 305: Cut shapes of the second fiber composite material housing base 220 and the first coating layer 130, to form a second housing 320.

For specific content of step 305, refer to step 104, and details are not described herein again.

In this embodiment of this application, the first fiber prepreg 210 is added. That is, in a multi-layer stacked sheet structure, a composite structure of an effect layer (a plurality of film plating layers or a hot stamping layer) and a rubbed-texture layer is used, to achieve spatial effect of a rear cover made of a fiber composite material, improve appearance aesthetics of the fiber composite material used in the rear cover, and form differentiated effect. In addition, when both the first coating layer 130 and the second fiber composite material housing base 220 are colorless and transparent, ink may be sprayed on the surface that is of the second fiber composite material housing base 220 and that is away from the first coating layer 130, to form the second coating layer 310, to implement shielding and bottoming functions.

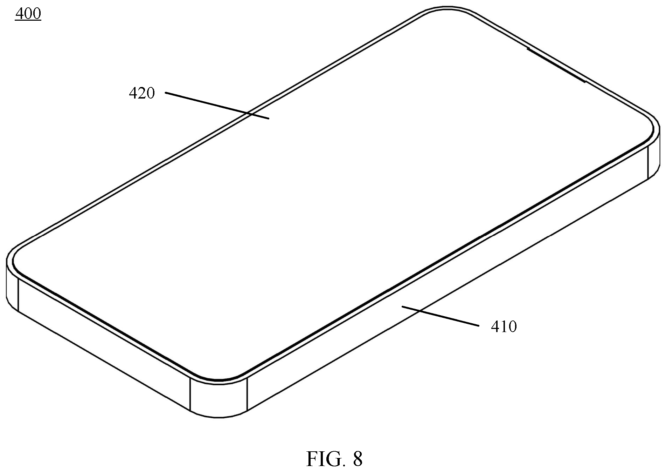

FIG. 8 is a diagram of an electronic device according to an embodiment of this application.

As shown in FIG. 8, the electronic device 400 provided in this application may include a housing 410. The housing 410 may be the first housing 230 in FIG. 6 or the second housing 320 in FIG. 7. In other words, the first housing 230 or the second housing 320 includes the composite material structure provided in embodiments of this application, or the first housing 230 or the second housing 320 may be manufactured by using the composite material structure provided in embodiments of this application. The composite material structure may be specifically shown in FIG. 2 to FIG. 5. The composite material structure includes the first fiber prepreg 210 shown in FIG. 2 to FIG. 5.

In some embodiments, the electronic device 400 further includes a transparent cover 420 that covers the housing 410. The housing 410 and the transparent cover 420 cooperate to form accommodation space. Elements such as a display module, a touch module, a chip, a battery, and a circuit mainboard of the electronic device 400 are disposed in the accommodation space. A surface that is of the transparent cover 420 and that is away from the housing 410 is a touch display surface of the electronic device 400.

It should be noted that the electronic device 400 may be an electronic device having a housing. The electronic device 400 in this embodiment of this application may include a mobile terminal such as a mobile phone, a wearable device, a smartwatch, a tablet computer, an e-reader, a notebook computer, a laptop computer, a mobile computer, an augmented reality device, a virtual reality device, a palmtop game console, or the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A composite material structure, comprising at least one layer of first fiber prepreg, wherein the first fiber prepreg comprises a fiber sheet and resin wrapping the fiber sheet; and
the fiber sheet comprises a fiber fabric and a plurality of film plating layers located on a surface of the fiber fabric, and a difference between refractive indexes of two adjacent layers of the plurality of film plating layers is greater than or equal to 0.4.

2. The composite material structure according to claim 1, wherein the plurality of film plating layers comprise a plurality of first plating layers and a plurality of second plating layers that are alternately stacked, and a total thickness of the first plating layers and the second plating layers ranges from 600 nm to 2000 nm.

3. The composite material structure according to claim 2, wherein the first plating layer is any one of silicon dioxide, zirconium dioxide, or monocrystalline silicon, and the second plating layer is any one of niobium pentoxide, titanium dioxide, or silicon nitride.

4. The composite material structure according to any one of claims 1 to 3, wherein the resin wrapping the fiber sheet is modified resin containing fluorine, and a refractive index of the modified resin containing fluorine ranges from 1.3 to 1.4.

5. The composite material structure according to any one of claims 1 to 4, wherein the composite material structure further comprises at least one layer of second fiber prepreg stacked with the first fiber prepreg, and the second fiber prepreg comprises a fiber woven fabric and resin wrapping the fiber woven fabric.

6. The composite material structure according to claim 5, wherein the second fiber prepreg located at an upper layer of the first fiber prepreg is colorless and transparent.

7. The composite material structure according to any one of claims 1 to 6, wherein a thickness of one layer of first fiber prepreg ranges from 0.07 mm to 0.15 mm.

8. The composite material structure according to any one of claims 1 to 7, wherein a material of the fiber fabric comprises any one of the following: glass fiber, basalt fiber, carbon fiber, aramid fiber, ceramic fiber, polyethylene terephthalate fiber, ultra-high molecular weight polyethylene fiber, poly(p-phenylene benzobisoxazole) fiber, polyimide fiber, polypropylene fiber, bast and leaf fiber, and bamboo fiber.

9. A composite material structure, comprising at least one layer of first fiber prepreg, wherein the first fiber prepreg comprises a fiber sheet and resin wrapping the fiber sheet; and
the fiber sheet comprises a fiber fabric and a plurality of film plating layers located on a surface of the fiber fabric, and the plurality of film plating layers comprise a metal plating layer and third plating layers disposed on two sides of the metal plating layer.

10. The composite material structure according to claim 9, wherein the metal plating layer is any one of gold, silver, aluminum, indium, nickel, titanium, or chromium, and the third plating layer is any one of silicon dioxide, zirconium dioxide, or monocrystalline silicon.

11. The composite material structure according to claim 9 or 10, wherein the resin wrapping the fiber sheet is modified resin containing fluorine, and a refractive index of the modified resin containing fluorine ranges from 1.3 to 1.4.

12. The composite material structure according to any one of claims 9 to 11, wherein a total thickness of the plurality of film plating layers ranges from 50 nm to 400 nm, and a thickness of the metal plating layer ranges from 2 nm to 20 nm.

13. The composite material structure according to any one of claims 9 to 12, wherein the composite material structure further comprises at least one layer of second fiber prepreg stacked with the first fiber prepreg, and the second fiber prepreg comprises a fiber woven fabric and resin wrapping the fiber woven fabric.

14. The composite material structure according to claim 13, wherein the second fiber prepreg located at an upper layer of the first fiber prepreg is colorless and transparent.

15. The composite material structure according to any one of claims 9 to 14, wherein a thickness of one layer of first fiber prepreg ranges from 0.07 mm to 0.15 mm.

16. The composite material structure according to any one of claims 9 to 15, wherein a material of the fiber fabric comprises any one of the following: glass fiber, basalt fiber, carbon fiber, aramid fiber, ceramic fiber, polyethylene terephthalate fiber, ultra-high molecular weight polyethylene fiber, poly(p-phenylene benzobisoxazole) fiber, polyimide fiber, polypropylene fiber, bast and leaf fiber, and bamboo fiber.

17. A composite material structure, comprising at least one layer of first fiber prepreg, wherein the first fiber prepreg comprises a fiber sheet and resin wrapping the fiber sheet; and
the fiber sheet comprises a fiber fabric and a hot stamping layer located on a surface of the fiber fabric, and the hot stamping layer is formed on the surface of the fiber fabric through a hot stamping process.

18. The composite material structure according to claim 17, wherein the hot stamping layer is transferred onto one surface of the fiber fabric through the hot stamping process, or the hot stamping layer is transferred onto both surfaces of the fiber fabric through the hot stamping process.

19. The composite material structure according to claim 17 or 18, wherein a thickness of the hot stamping layer ranges from 0.01 mm to 0.02 mm.

20. The composite material structure according to any one of claims 17 to 19, wherein the hot stamping layer comprises any one of the following: gold, silver, aluminum, indium, nickel, titanium, and chromium; and
a material of the fiber fabric comprises any one of the following: glass fiber, basalt fiber, carbon fiber, aramid fiber, ceramic fiber, polyethylene terephthalate fiber, ultra-high molecular weight polyethylene fiber, poly(p-phenylene benzobisoxazole) fiber, polyimide fiber, polypropylene fiber, bast and leaf fiber, and bamboo fiber.

21. The composite material structure according to any one of claims 17 to 20, wherein the resin wrapping the fiber sheet is modified resin containing fluorine, and a refractive index of the modified resin containing fluorine ranges from 1.3 to 1.4.

22. The composite material structure according to any one of claims 17 to 21, wherein the composite material structure further comprises at least one layer of second fiber prepreg stacked with the first fiber prepreg, and the second fiber prepreg comprises a fiber woven fabric and resin wrapping the fiber woven fabric.

23. The composite material structure according to claim 22, wherein the second fiber prepreg located at an upper layer of the first fiber prepreg is colorless and transparent.

24. The composite material structure according to any one of claims 17 to 23, wherein a thickness of one layer of first fiber prepreg ranges from 0.07 mm to 0.15 mm.

25. A housing, wherein the housing is manufactured by using the composite material structure according to any one of claims 1 to 8, or is manufactured by using the composite material structure according to any one of claims 9 to 16, or is manufactured by using the composite material structure according to any one of claims 17 to 24.

26. An electronic device, comprising the housing according to claim 25.
